# EUROPEAN PATENT SPECIFICATION

(11) **EP 3 336 024 B1**
(45) Date of publication and mention of the grant of the patent: **26.05.2021**
(21) Application number: 17788095.2
(22) Date of filing: 02.08.2017
(51) Int. Cl.: H01L 21/677, H05K 13/02, G01R 31/28, H05K 13/08, H01L 21/67

(54) **ELECTRONIC COMPONENT MOVING DEVICE AND ELECTRONIC COMPONENT CONVEYING DEVICE**
BEWEGUNGSVORRICHTUNG FÜR ELEKTRONISCHE KOMPONENTEN UND FÖRDERVORRICHTUNG FÜR ELEKTRONISCHE KOMPONENTEN
DISPOSITIF DE DÉPLACEMENT DE COMPOSANTS ÉLECTRONIQUES ET DISPOSITIF DE TRANSPORT DE COMPOSANTS ÉLECTRONIQUES

(30) Priority: 18.10.2016 JP 2016204065
(43) Date of publication of application: 20.06.2018
(73) Proprietor: Ueno Seiki Co., Ltd., Onga-gun, Fukuoka 807-0052 (JP)
(72) Inventor: KIMURA, Hiroyuki, Onga-gun, Fukuoka 807-0052 (JP)
(74) Representative: Daub, Thomas
(86) International application number: PCT/JP2017/028147
(87) International publication number: WO 2018/074034

(56) References cited:
- WO-A1-2012/073282
- WO-A1-2014/087489
- WO-A1-2014/087491
- JP-A- 2006 196 524
- JP-B1- 5 975 556
- JP-B1- 5 999 795
- US-A1- 2016 216 322

## Description

### Technical Field

The present invention relates to an electronic components moving apparatus for rotationally moving electronic components and an electronic components conveyor system which includes the electronic components moving apparatus and in which various types of processing operations are performed on electronic components while conveying them in a line.

### Background Art

Processing operations such as quality checking, packaging and the like are performed on electronic components successively in back end process. For example, electronic components are measured for electric property and are checked for quality by inspecting visually their external appearances, are engraved with laser marking, and are classified in terms of quality for packing in classified container. Electronic components are conveyed along a conveying path in such a way as to move around along processing units so that those processing operations are performed thereon. Alternatively, there are cases where electronic components are conveyed along the conveying path with no specific processing operation performed thereon for repacking by changing containers to meet a type of container to be used in machinery in the following step or to meet a request from a customer.

Electronic components conveyor systems are propagated as a system for performing processing operations such as quality checking and packing while conveying electronic components in a line. The electronic components conveyor system includes a holding portion for holding an electronic component, a rotary table on which a plurality of holding portions are arranged around a rotational axis and which rotates intermittently and various types of processing units which are disposed directly below a circumference of the rotary table. The holding portions are supported on sleeves having their axes which are at right angles to a rotational plane of the rotary table. Reciprocating driving units are disposed on an opposite side to the side where the processing units are disposed across the holding portions.

The reciprocating driving unit lifts down the holding unit which arrives at a position lying directly above the processing unit by the rotary table towards the processing unit. This reciprocating driving unit includes a motor and a slide pusher. The slide pusher is a pressing member such as a rod which can slide along a rail and is disposed above the holding portion. The motor constitutes a power source which imparts a thrusting force to the slide pusher and is disposed above the slide pusher. Namely, the holding portion, the motor and the slide pusher are aligned in a straight line along a direction in which the holding portion moves towards the processing unit. The holding portion is lowered when the slide pusher is brought into abutment with a rear end of the holding portion to push it down towards the processing unit.

In recent years, electronic components conveyor systems including a rotary pickup have been propagating. The rotary pickup is similar to the rotary table in that holding portions are disposed around a rotational axis but is different therefrom in that tips of the holding portions are oriented radially outwards.

This rotary pickup is interposed between an electronic component container unit and a rotary table which makes up a conveying path and is designed to relay electronic components therebetween (refer, for example, to Patent Literature 1). Additionally, since the tips of the holding portions are oriented radially outwards in the rotary pickup, by arranging a plurality of such rotary pickups in succession, it becomes easy to receive electronic components from one rotary pickup and pass them onto another. Due to this, it is expected to form a conveying path by arranging a plurality of rotary pickups in succession in place of the rotary table (refer, for example, to Patent Literature 2).

Since the rotary pickups are intended to relay electronic components therebetween and it is premised that a plurality of rotary pickups are used in succession, the rotary pickup is clearly smaller in diameter than the rotary table. For example, a rotary table has a diameter of 400 mm, while a rotary pickup has a diameter of 170 mm. Thus, the rotary pickup is lighter in weight than the rotary table, and when rotating, the rotary pickup needs a smaller inertia of moment than that of the rotary table. Thus, the rotary pickup can rotate at higher speeds than the rotary table. By applying such rotary pickups to an electronic components conveyor system, a conveying speed of electronic components is enhanced.

In the rotary pickup, too, in a position where the holding portion is oriented towards the processing unit, the container unit or the rotary table, the holding portion needs to reciprocate towards and from those devices for reception and transport of an electronic component therebetween. Then, in many cases, reciprocating driving units are also provided on the rotary pickup.

In the conventional reciprocating driving unit, however, the holding portion, the motor and the slide pusher are aligned in a straight line along the direction in which the holding portion moves towards the processing unit. Due to this, when the reciprocating driving unit is mounted on the rotary pickup, the holding portion, the slide pusher and the motor are aligned in such a way as to extend towards the center of the rotary pickup along a radial direction thereof. On a rotary pickup of a small diameter, such reciprocating driving units are collected around the center of the rotary pickup and come into physical interference with one another. Thus, a number of reciprocating driving units cannot be arranged on the rotary pickup.

### Prior Art Literatures

### Patent Literatures

Patent Literature 1: JP-A-2009-154889
Patent Literature 2: JP-B2-5376386

Further prior art is disclosed by WO 2014/087489 A1 which discloses an electronic components moving apparatus. The apparatus comprises a holding portion for holding an electronic component at a tip thereof. The apparatus comprises a projecting portion which projects from the holding portion. The apparatus comprises a rotor on which the holding portion is disposed around a rotational axis with the tip of the holding portion oriented radially outwards, and which intermittently rotates the holding portion about the rotational axis through a predetermined angle each time. The apparatus comprises a reciprocating driving portion which is set in at least one of stopping positions of the holding portion to advance the holding portion radially outwards of the rotor. The apparatus comprises a projecting portion which projects from the holding portion.

Document WO 2014/087491 A1 discloses a similar arrangement, however discloses the reciprocating motor to be oriented differently and uses a sliding pusher for movement of the holding portion.

### Summary of the Invention

### Problem that the Invention is to Solve

As a tendency propagates to provide electronic components conveyor systems with multiple functions, there is a growing demand for arranging more processing units around a rotary pickup. Conventionally, this demand has been understood to be the same as a demand for arranging a number of long and large reciprocating driving units towards a center of the rotary pickup along a radial direction thereof. This demand can be satisfied by enlarging the size of the rotary pickup. However, the rotary pickup is originally advantageous in that since the rotary pickup is small in size, it can rotate at higher speeds. In case the rotary pickup is enlarged in size, its advantage in higher rotation speeds is lost by a large inertia, and hence, the advantageous reason that the rotary pickup is mounted on the electronic components conveyor system is reduced. On the contrary, in case the number of reciprocating driving units which are mounted on the rotary pickup is limited, the demand for providing the electronic components conveyor system with multiple functions cannot be met, and it is just like putting the cart before the horse.

Thus, in the rotary pickup in which the holding portions are arranged around the rotational axis in such a way that the tips of the holding portions are oriented radially outwards, there has been a problem of how to increase positions where holding portions need to reciprocate without enlarging the size of the rotary pickup.

The invention has been proposed with a view to solving the problem, and an object thereof is to provide an electronic components moving apparatus in which a number of positions where holding portions need to reciprocate can be disposed on a circumference of a rotary pickup while maintaining the advantage in smallness in size of the rotary pickup and an electronic components conveyor system which includes the electronic components moving apparatus.

### Means for Solving the Problem

According to an embodiment of the invention, there is provided an electronic components moving apparatus including a holding portion for holding an electronic component at a tip thereof, a rotor on which the holding portion is disposed around a rotational axis with the tip of the holing portion oriented radially outwards and which rotates intermittently the holding portion about a center of the rotational axis through a predetermined angle each time, a reciprocating driving portion which is set in at least one of stopping positions of the holding portion to advance the reciprocating driving portion radially outwards of the rotor, and a projecting portion which projects from the holding portion. The reciprocating driving portion includes a slide pusher which is placed so as to slide radially outwards of the rotor on a rail and which is configured to be brought into abutment with the projecting portion to push out the projecting portion, and a reciprocating driving motor which is a drive source of the slide pusher. The slide pusher and the reciprocating driving motor are arranged so that the holding portion, the slide pusher and the reciprocating driving motor are aligned along a direction which is substantially at right angles to a rotational plane of the rotor when the holding portion stops in the position where the reciprocating driving portion is placed, wherein the rail is disposed on an inner side of the reciprocating driving motor in a radial direction of the rotor.

The holding portion may include the projecting portion which projects from a side portion of a main body thereof. The slide pusher may have a radially outward tip which lies closer to a central side of the rotor than the projecting portion and may be disposed so as to overlap the holding portion when the holding portion stops in the position where the reciprocating driving portion is placed.

The slide pusher may be placed so as to move parallel to an advancing direction of the holding portion. The reciprocating driving motor may have a motor shaft which is at right angles to a moving direction of the slide pusher. A cam mechanism may be provided so as to be interposed between the slide pusher and the reciprocating driving motor to convert a rotational thrusting force of the reciprocating driving motor into a rectilinear thrusting force acting in the moving direction of the slide pusher.

The reciprocating driving portion may include a spring member for accumulating a biasing force with which the holding portion and the slide pusher are returned in the direction of a center of the rotor. The slide pusher may push out the holding portion outwards of the rotor against the biasing force of the spring member.

The electronic components moving apparatus may include a rotating motor which supports rotatably the center of the rotor by a motor shaft thereof and which is configured to rotate the rotor intermittently and a base plate which is interposed to expand between the rotor and the rotating the motor, the reciprocating driving motor may be fixed to a surface of the base plate where the rotating motor is attached, and the slide pusher may be placed on a surface of a side of the base plate which lies to face the rotor.

When the holding portion stops in the position where the reciprocating driving portion is placed, the slide pusher may be disposed directly behind the holding portion, that is, a side of the holding portion which faces a motor flange or may be disposed so as to deviate in a radial direction or a tangential direction of the rotor or a direction which is parallel to the rotational plane of the rotor and which intersects obliquely the radial direction directly on a rear side of the holding portion, and the reciprocating driving motor may be disposed directly behind the holding portion, that is, the side of the holding portion which faces the motor flange or may be disposed so as to deviate in the radial direction or the tangential direction of the rotor or the direction which is parallel to the rotational plane of the rotor and which intersects obliquely the radial direction directly on the rear side of the holding portion.

The rotor may include a plurality of holding portions like the holding portion and may stop the holding portions in angular positions which result from dividing a whole circumference of the rotor by the number of holding portions, and reciprocating driving portions like the reciprocating driving portion may be disposed individually in all of stopping positions of the holding portions.

The slide pusher may include a voice coil motor which is placed radially outwards of the rotor with its rod oriented towards the projecting portion, and the voice coil motor may push out the holding portion by sliding of the slide pusher and may control a load exerted on the electronic component by means of a thrusting force of the rod.

According to another certain embodiment of the invention, there is provided an electronic components conveyor system including the electronic components moving apparatus described above and configured to apply various processing operations to electronic components while conveying them in a line.

The electronic components conveyor system may include a supply unit for containing the electronic components to which the various processing operations are applied, a handler for conveying the electronic components in the supply unit in a line along an annular conveying path, various types of processing units which are disposed along the conveying path, and a container unit for containing the electronic components for containing the electronic components which have been conveyed by the handler. The electronic components moving apparatus may be disposed between the supply unit and the conveying path as a relay unit which picks up the electronic component in the supply unit to pass it on to the handler.

Additionally, the electronic components conveyor system may include a supply unit for containing the electronic components to which the various processing operations are applied, a handler for conveying the electronic components in the supply unit in a line along an annular conveying path, various types of processing units which are disposed along the conveying path, and a container unit for containing the electronic components for containing the electronic components which have been conveyed by the handler. A plurality of electronic components moving apparatuses like the electronic components moving apparatus may be disposed in succession as the handler.

### Advantage of the Invention

According to the invention, since the reciprocating driving unit extends along the rotational axis of the rotor, even though the reciprocating driving units are placed at the respective angles of the rotor, these reciprocating units do not interfere with one another physically, and a multiplicity of positions where the holding portion needs to reciprocate can be disposed while maintaining the smallness in size of the rotor.

### Brief Description of Drawings

Fig. 1 is a front view of an electronic components moving apparatus, which shows a state in which suction nozzles have not yet arrived at reciprocating driving units.
Fig. 2 is a side view of the electronic components moving apparatus, which shows a state in which the suction nozzles have arrived at the reciprocating driving units.
Fig. 3 is a top view of an electronic components conveyor system according to a first application example.
Fig. 4 is a side sectional view of the electronic components conveyor system according to the first application example.
Fig. 5 is a front view of an electronic components moving apparatus which the electronic components conveyor system according to the first application example includes, which shows suction nozzles have not yet arrived at reciprocating driving units.
Fig. 6 is a side sectional view of the electronic components moving apparatus which the electronic components conveyor system according to the first application example includes, which shows the suction nozzles have arrived at the reciprocating driving units.
Fig. 7 is a schematic view showing a state in which the suction nozzle is passing a position where a part detection sensor is placed without holding an electronic component.
Fig. 8 is a schematic view showing a state in which the suction nozzle is passing the position where the part detection sensor is placed while holding an electronic component.
Fig. 9 is a schematic view showing another example of a suction nozzle.
Fig. 10 is a side view of an electronic components conveyor system according to a second application example.
Fig. 11 is a side view showing a rotary table which a handler of the electronic components conveyor system according to the second application example includes.
Fig. 12 is a side view of an electronic components moving apparatus according to another embodiment, which shows a state in which suction nozzles have arrived at reciprocating driving units.

### Mode for Carrying out the Invention

Hereinafter, referring to the drawings, embodiments of an electronic components moving apparatus according to the invention and application examples thereof will be described in detail.

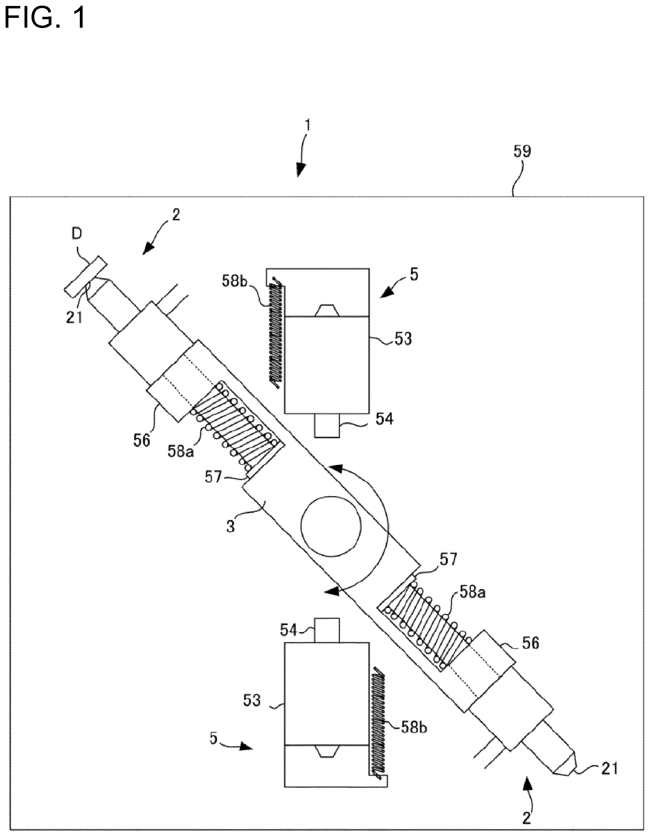

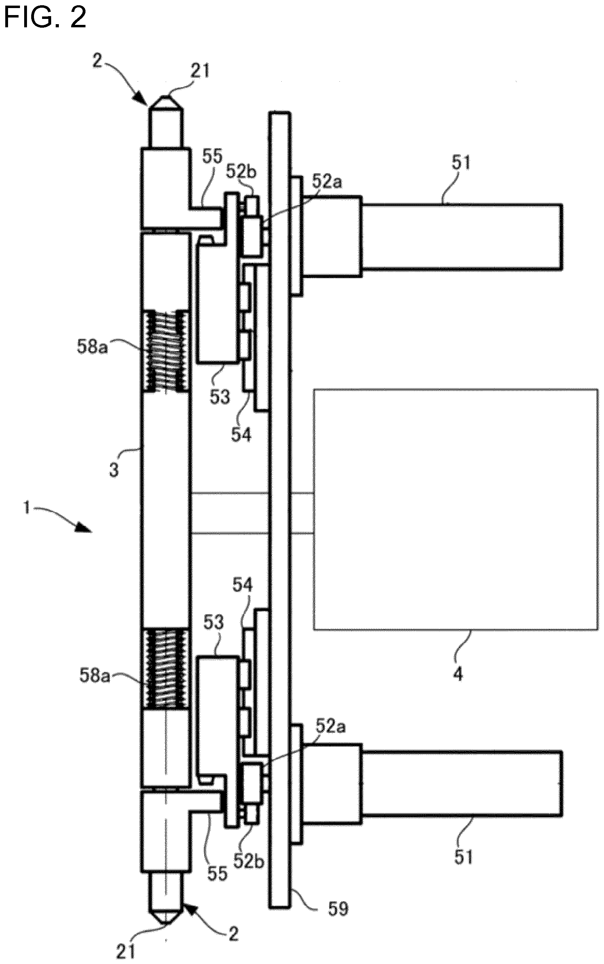

An electronic components moving apparatus 1 shown in Figs. 1 and 2 is called a rotary pickup from its original application purpose. This electronic components moving apparatus 1 rotationally moves electronic components D in such a way as to draw an annular locus or an arc-shaped locus. The electronic components moving apparatus 1 stops temporarily the electronic components D halfway along the moving locus or at an initiating end and a terminating end of the moving locus to process the electronic components D. The electronic components moving apparatus 1 configured in this way may include suction nozzles 2, a rotor 3, and a motor 4.

The suction nozzle 2 is an example of a holding portion which holds an electronic component D. The suction nozzle 2 has a cylindrical shape having a suction hole 21 at a tip thereof and holds an electronic component D by sucking to hold it at the suction hole 21. The rotor 3 is a feeding platform including the suction nozzles 2. The rotor 3 is supported rotatably on a rotational shaft of the motor 4 and supports the suction nozzles 2 in positions lying away from the rotational shaft of the motor 4, moving the suction nozzles 2 in an annular or arc-shaped path. The motor 4 is a servomotor or the like and constitutes a power source for rotating the rotor 3.

This electronic components moving apparatus 1 includes two suction nozzles 2. The rotor 3 is made up of two arms which extend from the rotational shaft of the motor 4 in directions which face each other diametrically at 180 degrees. The electronic components moving apparatus 1 may include one suction nozzle 2 or three or more suction nozzles 2. When the electronic components moving apparatus 1 includes one suction nozzle 2, the rotor 3 is made up of one arm which is supported rotatably by the rotational shaft of the motor 4 at one end and which has one suction nozzle 2 provided at the other end thereof. When the electronic components moving apparatus 1 includes three or more suction nozzles 2, the rotor 3 has a star or circular disc shape in which arms which extend radially are disposed at equal intervals in a circumferential direction. A center of the rotor 3 from which the arms extend radially is supported rotatably on the rotational shaft of the motor 4, and suction nozzles 2 are disposed at tip of the arms or along an outer circumference of the circular disc at equal intervals.

In addition, when the electronic components moving apparatus 1 includes two suction nozzles 2, the motor 4 rotates the rotor 3 through 180 degrees in a reciprocating fashion or rotates the rotor 3 circularly in one direction and stops the rotor 3 temporarily at a 0-degree position and a 180-degree position. When the electronic components moving apparatus 1 includes one suction nozzle 2, the motor 4 rotates the rotor 3 through 180 degrees in the reciprocating fashion or rotates the rotor 3 circularly through 180 degrees in one direction and stops the rotor temporarily thereat. When the electronic components moving apparatus 1 includes three or more suction nozzles 2, the motor 4 rotates the rotor 3 at angular intervals corresponding to angular intervals at which the suction nozzles 3 are disposed and stops the rotor 3 temporarily at every one of the angular intervals at which the suction nozzles 2 are disposed.

The suction nozzle 2 is supplied with a vacuum from an exterior portion to hold an electronic component D at the suction hole 21. A cylindrical axis of the suction nozzle 2 extends along a radial direction of the rotor 3, and an axial extension of the suction nozzle 2 passes through the center of the rotor 3. The suction nozzle 2 projects radially outwards of the rotor 3, so that the suction hole 21 is oriented radially outwards of the rotor 3. When a plurality of suction nozzles 2 are provided, the suction nozzles 2 are disposed at equal intervals in a circumferential direction and extend radially outwards from positions which are equidistant from the center of the rotor 3, having the same overall length. Namely, the plurality of suction nozzles 2 are positioned on the same locus which is concentric with the rotor 3, move along the same locus and are stopped temporarily at the same positions.

The suction nozzle 2 is disposed on the rotor 3 via a sleeve 56. The sleeve 56 has an axis which follows the radial direction of the rotor 3. The suction nozzle 2 is supported on the sleeve 56 so as to slide in the sleeve 56 in such a way as to advance radially outwards of the rotor 3 and withdraw radially inwards of the rotor 3 towards the center thereof. Due to this, the electronic components moving apparatus 1 includes a reciprocating driving unit 5 which imparts a thrusting force acting in the radial direction of the rotor 3 to the suction nozzle 2.

The reciprocating driving unit 5 includes a rotating motor 51, a cylindrical cam 52a, a cam follower 52b and a slide pusher 53. Additionally, a projecting portion 55 projects from a side portion of a main body of the suction nozzle 2. The rotating motor 51 constitutes a power source for advancing the suction nozzle 2. The cylindrical cam 52a and the cam follower 52b convert a rotational motion of the rotating motor 51 into a rectilinear motion. The rectilinear motion is directed radially outwards of the rotor 3. The slide pusher 53 has the cam follower 52b and receives a thrusting force acting radially outwards of the rotor 3, pushing out the suction nozzle 2 radially outwards using the projecting portion 55 of the suction nozzle 2 as a pushing-out action triggering point.

Further, the reciprocating driving unit 5 includes a compression spring 58a which accumulates a biasing force for withdrawing the suction nozzle 2 as the suction nozzle 2 advances and a tension spring 58b which accumulates a biasing force for withdrawing the slide pusher 53 as the slide pusher 53 advances and withdraws the suction nozzle 2.

A motor flange 59 is interposed between the motor 4 and the rotor 3. The motor flange 59 is a base plate which expands parallel to the rotor 3. The rotating motor 51 is attached to the motor flange 59 from a rear surface of the motor flange 59 which faces the motor 4 in such a way as to be aligned along a circumference of the motor 4 with a motor shaft thereof allowed to penetrate the motor flange 50 to a front surface thereof. A part of an outer circumference of the cylindrical cam 52a protrudes moderately, so that the cylindrical cam 52 is formed into the shape of an egg. The cylindrical cam 52a is supported rotatably on the motor shaft of the rotating motor 51.

A rail 54 is laid out on the front surface of the motor flange 59 so as to extend along a radially outward direction of the rotor 3. The slide pusher 53 fits on this rail 54 in such a way as to slide thereon and is disposed between the rotor 3 and the motor flange 59 as viewed in the direction of a rotational axis of the rotor 3. This slide pusher 53 overlaps the suction nozzle 2 to become parallel to the suction nozzle 2 when the suction nozzle 2 arrives at the position where the reciprocating driving unit 5 is placed.

The cam follower 52b is a cylindrical member and is fixed to the slide pusher 53. The tension spring 58b is placed so as to extend along the rail 54 on the motor flange 59 and fixes the slide pusher 53 in place at one end thereof which lies to face a radially outward end of the rotor. The tension spring 58b is biased so as to be contracted towards the center of the rotor 3.

The projecting portion 55 projects from a side surface of the main body of the suction nozzle 2 in the direction of the motor flange 59 across the rotor 3, projecting to the front of the cam follower 52b. Namely, when the suction nozzle 2 arrives at the position where the reciprocating driving unit 5 is placed, the projecting portion 55 projects on an imaginary line which connects a most withdrawn position of an abutment portion of the slide pusher 53 and a most advanced position of the abutment portion of the slide pusher 53.

The abutment portion of the slide pusher 53 is the radially outward end of the rotor 3. The most withdrawn position is a position resulting when the cam follower 52b moves nearest to a center of the cylindrical cam 52a and the slide pusher 53 is pulled in towards the center of the rotor 3 by the tension spring 58b. The most advanced position is a position resulting when the cam follower 52b comes to lie farthest away from the center of the cylindrical cam 52a and the slide pusher 53 is advanced radially outwards of the rotor 3 against the biasing force of the tension spring 58b.

The compression spring 58a is fitted in the suction nozzle 2. In the suction nozzle 2, a flange 57 extends from a side surface of the main body thereof. The flange 57 is situated closer to the center of the rotor 3 than the sleeve 56. The compression spring 58a is placed using the flange 57 and the sleeve 56 as spring seats and is biased in a direction in which the flange 57 is caused to move away from the sleeve 56. Namely, the compression spring 58a pushes in the flange 57 of the suction nozzle 2 towards the center of the rotor 3.

According to the construction of the reciprocating driving unit 5, the compression spring 58a is mounted on the rotor 3, and the rotating motor 51, the cylindrical cam 52a and the cam follower 52b, and the slide pusher 53 are placed on the motor flange 59. Consequently, the lightness in weight of the rotor 3 is not lost by the reciprocating driving unit 5.

Additionally, according to the construction of the reciprocating driving unit 5, the slide pusher 53 and the rotating motor 51 are disposed so that the suction nozzle 2, the slide pusher 53 and the rotating motor 51 are aligned in a direction which is at right angles to a direction in which the suction nozzle 2 reciprocates when the suction nozzle 2 arrives at the position where the reciprocating driving unit 5 is placed. The direction which is at right angles to the reciprocating direction of the suction nozzle 2 means, in other words, a direction which is substantially at right angles to a moving direction in which the suction nozzle 2 moves radially outwards of the rotor 3, a direction which substantially follows a rotational axis of the rotor 3 or a direction which is substantially at right angles to a rotational plane of the rotor 3.

When used herein, "substantially" means that the direction concerned does not have to be strictly aligned in a straight line with the direction which is at right angles to the moving direction of the suction nozzle 2 or the direction which follows the rotational axis of the rotor 3, although the slide pusher 53 should lie directly behind the suction nozzle 2 and the rotating motor 51 should lie directly behind the slide pusher 53. In this embodiment, "directly behind" denotes the direction of the motor flange 59 in relation to the suction muzzle 2. "Directly on a or the rear side" permits in its meaning a position which is situated directly behind the suction nozzle 2 or the pusher plate 53, a position which is not situated strictly directly behind the suction nozzle 2 or the pusher plate 53 but is situated in a position which deviates in the radial direction of the rotor 3 on the rear side thereof, a position which is not situated strictly directly on the rear side of the suction nozzle 2 or the pusher plate 53 but is situated in a position which deviates in a tangential direction of the rotor 3 or a position which is not situated strictly on the rear side of the suction nozzle 2 or the pusher plate 53 but is situated in a position which deviates in a direction which is parallel to the rotational plane of the rotor 3 and which intersects obliquely the radial direction of the rotor 3.

Namely, the reciprocating driving units 5 which advance the corresponding suction nozzles 2 in the radially outward direction of the rotor 3 do not follow the radial direction of the rotor 3, are not collected at the center of the rotor 3 and extend along the rotational axis of the rotor 3, whereby the reciprocating driving units 5 do not interfere with each other physically. This configuration allows a number of reciprocating driving units 5 to be disposed on the electronic components moving apparatus 1 to such an extent that a width of the slide pusher 53 or a width of the rotating motor 51 which is greater permits. When seen from a direction which is at right angles to the rotational plane of the rotor 3, the slide pusher 53 and the rotating motor 51 are disposed in such a way that either the slide pusher 53 or the rotating motor 51 is contained in a greater area of the other.

In the electronic components moving apparatus 1 configured in the way described heretofore, when the motor 4 is driven to rotate the rotor 3 through 180 degrees and the suction nozzles 2 stop in the positions where the reciprocating driving units 5 are placed, in the reciprocating driving units 5, the rotating motor 51 is driven, the cylindrical cam 52a moves the cam follower 52b in a direction in which the cam follower 52b moves away from the center, and the slide pusher 53 moves radially outwards of the rotor 3 along the rail 54 against the biasing force of the tension spring 58b. The slide pusher 53 pushes out the projecting portion 55 which exist in the advancing direction radially outwards of the rotor 3, and the suction nozzle 2 including the projecting portion 55 advances radially outwards of the rotor 3 against the biasing force of the compression spring 58a.

In addition, in the reciprocating driving unit 5, when the suction nozzle 2 is withdrawn radially towards the center of the rotor 3, the rotating motor 51 is driven, and the cylindrical cam 52a causes the cam follower 52 to move towards the center. Then, the slide pusher 53 loses its trusting force provided by the cylindrical cam 52a and the cam follower 52b and is withdrawn radially along the rail 54 towards the center of the rotor 3 by means of the biasing force of the tension spring 58b. The projecting portion 55 and the slide pusher 53 are caused to move away from each other as a result of the withdrawal of the slide pusher 53, whereby the suction nozzle 2 is withdrawn radially towards the center of the rotor 3 by means of the biasing force of the compression spring 58a.

In this way, the electronic components moving apparatus 1 includes the rotor 3 on which the suction nozzles 2 are disposed around the rotational axis thereof with the tips of the suction nozzles 2 which hold electronic components D at the tips thereof oriented radially outwards. Additionally, in the electronic components moving apparatus 1, the reciprocating driving unit 5 is placed in at least one of the stopping positions of the suction nozzles 2 so as to advance the suction nozzle 2 radially outwards of the rotor 3. The projecting portion 55 is provided on the suction nozzle 2 so as to project therefrom. The reciprocating driving unit 5 includes the slide pusher 53 which is placed so as to slide radially outwards of the rotor 3 and which is configured to be brought into abutment with the projecting portion 55 to thereby push out the suction nozzle 2 and the rotating motor 51 which constitutes the drive source for the slide pusher 53.

Then, the slide pusher 53 and the rotating motor 51 are disposed so that the suction nozzle 2, the slide pusher 53 and the rotating motor 51 are aligned along the rotational axis of the rotor 3 when the suction nozzle 2 stops in the position where the reciprocating driving unit 5 is placed. By adopting this configuration, the reciprocating driving units 5 for advancing the corresponding suction nozzles 2 radially outwards of the rotor 3 do not follow the radial direction of the rotor 3, are not collected at the center of the rotor 3 and extend along the rotational axis of the rotor 3, whereby reciprocating driving units 5 are not brought into physical interference with each other.

This configuration allows a number of reciprocating driving units 5 to be disposed on the electronic components moving apparatus 1 to such an extent that the width of the slide pusher 53 or the width of the rotating motor 51 which is greater permits. Even though so many reciprocating driving units 5 are placed on the electronic components moving apparatus 1, the rotor 3 does not have to be enlarged in size, and hence, an electronic components conveyor system including the electronic components moving apparatus 1 can be provided with a multiplicity of functions while maintaining the advantage of the electronic components moving apparatus 1 in relation to its high speed rotating property.

The suction nozzle 2 is exemplified as the holding portion of an electronic component D. However, an electrostatic suction method, Bernoulli chuck method or a chuck mechanism for holding mechanically an electronic component D may be adopted as the holding portion.

Additionally, the projecting portion 55 is provided on the side portion of the main body of the suction nozzle 2 so as to project therefrom, and the slide pusher 53 has the radially outward end which lies closer to the center of the rotor 3 than the projecting portion 55 and is disposed so as to overlap the suction nozzle 2 when the suction nozzle 2 stops in the position where the reciprocating driving unit 5 is placed. By adopting this configuration, the slide pusher 53 can easily be disposed so as to follow the rotational axis of the rotor 3 in relation to the suction nozzle 2 which advances radially outwards of the rotor 3 without involving a complex motion converting mechanism.

In contrast with the complex motion converting mechanism mentioned above, the simple mechanism should be provided in which the slide pusher 53 is placed so as to move in parallel to the advancing direction of the suction nozzle 2, the rotating motor 51 has the motor shaft which is at right angles to the moving direction of the slide pusher 53, and the cam mechanism made up of the cylindrical cam 52a and the cam follower 52b is interposed between the slide pusher 53 and the rotating motor 51, whereby a rotational thrusting force of the rotating motor 51 is converted into a rectilinear thrusting force acting in the moving direction of the slide pusher 53.

Additionally, there are provided the motor 4 which supports rotatably the center of the rotor 3 by the motor shaft thereof and which rotates the rotor 3 intermittently and the motor flange 59 which is interposed between the rotor 3 and the motor 4 so as to expand therebetween to constitute the base plate. The rotating motor 51 is attached to the surface of the motor flange 59 to which the motor 4 is attached, and the slide pusher 53 is placed on the surface of the side of the motor flange 59 which lies to face the rotor 3.

Namely, the slide pusher 53 and the rotating motor 51 are not mounted on the rotor 3, and therefore, even though a number of reciprocating driving units 5 are mounted on the electronic components moving apparatus 1, the lightness in weight of the rotor 3 is not lost. Consequently, the high speed rotating property of the electronic components moving apparatus 1 is maintained even though a number of reciprocating driving units 5 are disposed thereon.

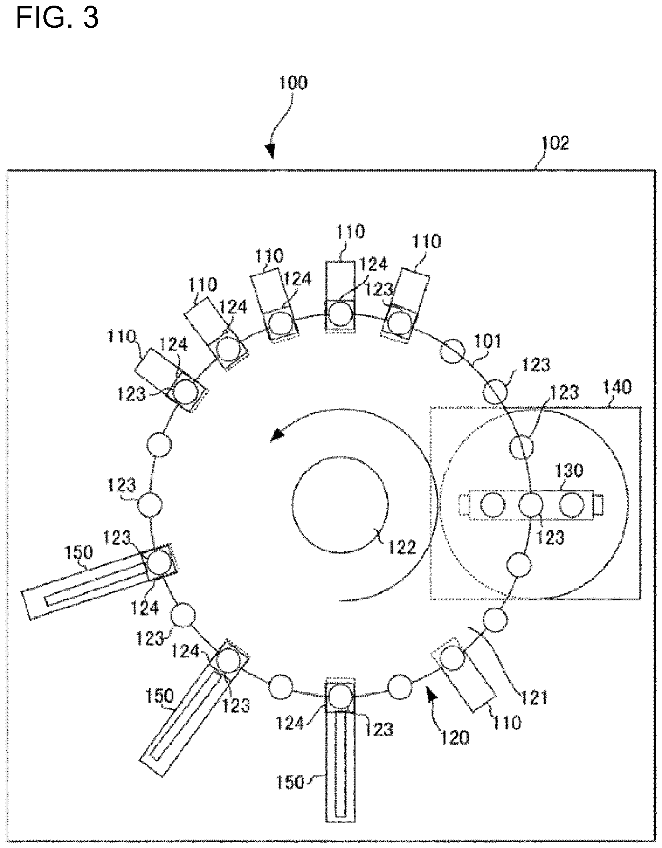

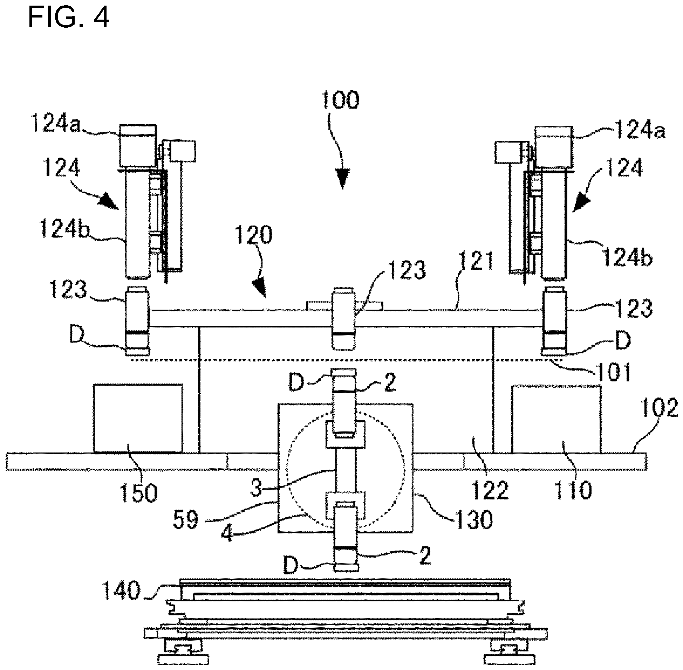

Application examples of this electronic components moving apparatus 1 will be described. In a first application example, the electronic components moving apparatus 1 is mounted on an electronic components conveyor system 100 shown in Figs. 3 and 4. In this electronic components conveyor system 100, electronic components D are placed on a conveying path 101, and the electronic components D are conveyed along the conveying path 101, whereby various processing operations are performed on the electronic components D on the conveying path 101. This electronic components conveyor system 100 includes various processing units 110 which are disposed along the conveying path 101, a handler 120 which makes up the conveying path 101, a relay unit 130 which provides electronic components D on to the conveying path 101, a supply unit 140 which supply unprocessed electronic component D, and container units 150 which contain electronic components D on which various required processing operations have been performed and which have been conveyed along the conveying path 101 to arrive thereat. This electronic components conveyor system 100 includes the electronic components moving apparatus 1 as the relay unit 130.

The handler 120 makes up the annular conveying path 101. Namely, the handler 120 is made up of a turret table 121 which makes up a base platform of a rotary system, a direct drive motor 122 which makes up a rotational power source for the turret table 121, suction nozzles 123 which are attached to the turret table 121 to suck and hold an electronic component D by means of a vacuum, and reciprocating driving units 124 which are attached directly above specific ones of the processing units 110 with the turret table 121 interposed therebetween to move the suction nozzles 123 towards the specific processing units 110.

The direct drive motor 122 is disposed on an upper surface of a base 102. The turret table 121 has a star shape or a circular disc shape on which arms are arranged radially, and the turret table 121 is supported rotatably at a circle center thereof by a rotational shaft of the direct drive motor 122. The turret table 21 expands horizontally in a position which lies higher than the upper surface of the base 102 and is rotated intermittently through a constant angle each time by the direct drive motor 122.

The suction nozzles 123 are attached to the turret table 121 along an outer circumferential edge thereof in positions which lie equidistant from the circle center and at equal intervals in a circumferential direction. Sleeves are provided along the outer circumferential edge of the turret table 121 so that their axes are at right angles to the upper surface of the base 102, and the suction nozzles 123 are fitted in the sleeves so as to slide therein with nozzle tips oriented towards the upper surface of the base 102 to thereby hold electronic components D at the nozzle tips.

The reciprocating driving units 124 each have an electric motor 124a and a rod 124b. The rod 124b is caused electrically to advance in a direction which is at right angles to the upper surface of the base 102, so that the rod 124b is brought into contact with a nozzle rear end of the suction nozzle 123 which has arrived at the processing unit 110, and further, the suction nozzle 123 is pushed in towards the processing unit 110 by the rod 124b. In this reciprocating driving unit 124, the rod 124b is placed so as to lie above the rear end of the suction nozzle 123 which reciprocates in a direction which is at right angles to a radial direction of the turret table 121, and the electric motor 124a is placed on a rear end of the rod 124b. Then, when the suction nozzle 123 comes to stop in a position where the reciprocating driving unit 124 is placed, the suction nozzle 123, the rod 124b and the electric motor 124a are aligned in a straight line along a direction in which the suction nozzle 123 is reciprocated.

According to this handler 120, the suction nozzles 123 which hold electronic components D move along a common locus and stop in common stopping positions. Namely, the common locus along which the suction nozzles 123 which hold electronic components D move becomes the annular conveying path 101. The processing units 110 are disposed directly below the stopping positions where the suction nozzles 123 are stopped. In the handler 120, the suction nozzle 123 which holds an electronic component D is pushed down towards the corresponding processing unit 110 by the corresponding reciprocating driving unit 124, so that the electronic component D is transferred to the processing unit 110.

The processing units 110 are disposed to perform processing operations required by individual electronic components D on them. Electronic components D are parts used in electric products and are packaged semiconductor devices such as discrete semiconductors including transistors, diodes, capacitors, resistors and the like and integrated circuits. Processing operations which are performed on these electronic components D are inspection, processing, posture correction, classification or a combination of some of the processing operations. Inspections to be performed are those which inspect visually for external appearance, electric property, light quantity and the like. Processing includes lead terminal bending, laser marking, solder application and the like. In posture correction, positions, orientations or both of electronic components D are corrected. In classification, products are classified into good products and products other than good products. Alternatively, good products are classified according to grades in terms of quality.

As the processing units 110 which execute the processing operations described above, there are disposed, for example, a camera unit for detecting a deviation in posture of an electronic component D, an X-Y-θ moving unit for correcting the posture of an electronic component D, an electric test unit for inspecting electric property of the electronic component D, a camera unit for inspecting visually an electronic component D for its external appearance, and a laser marking unit for marking an electronic component D whose inspection result is good.

The supply unit 140 and the container units 150 are disposed in stopping positions at both ends which hold all the processing units 110 therebetween. A wafer ring holder, a taping unit, a tray shifting unit or a parts feeder is raised as the supply unit 140 and the container units 150. When classification is included in the processing operations, in the electronic components conveyor system 100, two types of container units 150 are disposed for good products and products other than good products, and electronic components D which are determined to be good products are contained in container units 150 according to their ranks in quality.

The wafer ring holder moves a wafer ring which is made by affixing a wafer to a ring at the same level as a contained product. The taping unit transports longitudinally a carrier tape having pockets provided in parallel in a longitudinal direction as a contained product. The tray shifting unit moves a tray at the same level as contained products. The parts feeder uses a mortar-like bowl as a container and moves electronic components D from the bowl to a head end of a straight rail connected to the bowl by vibrating the bowl and the straight rail.

The relay unit 130 is disposed between the supply unit 140, the container unit 150 or both of them and the handler 120 to deal with a predetermined limitation. Namely, the relay unit 130 is disposed in case the suction nozzles 123 lie so far away from the supply unit 140 or the container units 150 or both of them that electronic components D cannot be transferred directly between the supply unit 140, the container units 150 or both of them and the handler 120. Alternatively, the relay unit 130 is disposed in case the suction nozzles 123 are oriented so differently from the supply unit 140, the container units 150 or both of them that electronic components D cannot be transferred directly between the supply unit 140, the container units 150 or both of them and the handler 120.

In this embodiment, the supply unit 140 is a wafer ring holder which is placed horizontally so that surfaces of wafer rings contained therein face a suction port of the suction nozzle 123 when the suction nozzle 123 arrives thereat, and the relay unit 130 is disposed, for example, between the supply unit 140 and the handler 120. The relay unit 130 is the electronic components moving apparatus 1 which is also called a rotary pickup and includes a pair of suction nozzles 2, 2 a rotor 3, a motor 4 and reciprocating driving units 5.

The suction nozzles 2, 2 receive electronic components D from the supply unit 140 and transfer them to the handler 120. The rotor 3 has two arms which extend in 180 degrees diametrically opposite directions and include the pair of suction nozzles 2, 2 which are provided at leading ends of the arms in such a way as to be oriented in 180 degrees diametrically opposite directions. The motor 4 supports the rotor 3 rotatably at proximal end portions of the two arms and causes the suction nozzles 2, 2 to face the supply unit 140 and the handler 120 sequentially. The reciprocating driving units 5 are placed individually in a position lying directly below the suction nozzle 2 which arrives at the supply unit 140 and a position lying directly above the suction nozzle 2 which arrives at the handler 120.

To describe this in detail, axial extensions of the suction nozzles 2, 2 both pass through a center of the rotor 3, and the suction nozzles 2, 2 project radially outwards of the rotor 3 from positions which lie equidistant from the center of the rotor 3 as proximal ends. Overall lengths of the suction nozzles 2, 2 are the same. Namely, tips of the suction nozzles 2, 2 are situated on the same circular traveling path which is concentric with the rotor 3.

The rotor 3 rotates repeatedly forwards and backwards through 180 degrees about a table center which is at right angles to a table plane as a rotational axis. The rotor 3 has a plane which is at right angles to a plane over which the conveying path 101 and the supply unit 140, which is the wafer ring holder, expand. Namely, the rotor 3 which includes the suction nozzles 2, 2 is placed vertically.

The positions of the suction nozzles 2, 2 are replaced intermittently, and the suction nozzles 2, 2 stop in a first stopping position where the suction nozzles 2, 2 are oriented directly upwards and a second stopping position where the suction nozzles 2, 2 are oriented directly downwards. The suction nozzle 2 which is oriented directly downwards faces an upwardly projecting pin of the supply unit 140 with an electronic component D, which is a wafer ring, interposed therebetween and then descends towards the electronic component D which is raised by the projecting pin to hold it. The suction nozzle 2 which is oriented directly upwards faces one point on the conveying path 101 which is defined by the handler 120 and then ascends to transfer the electronic component D picked up from the supply unit 140 to the handler 120.

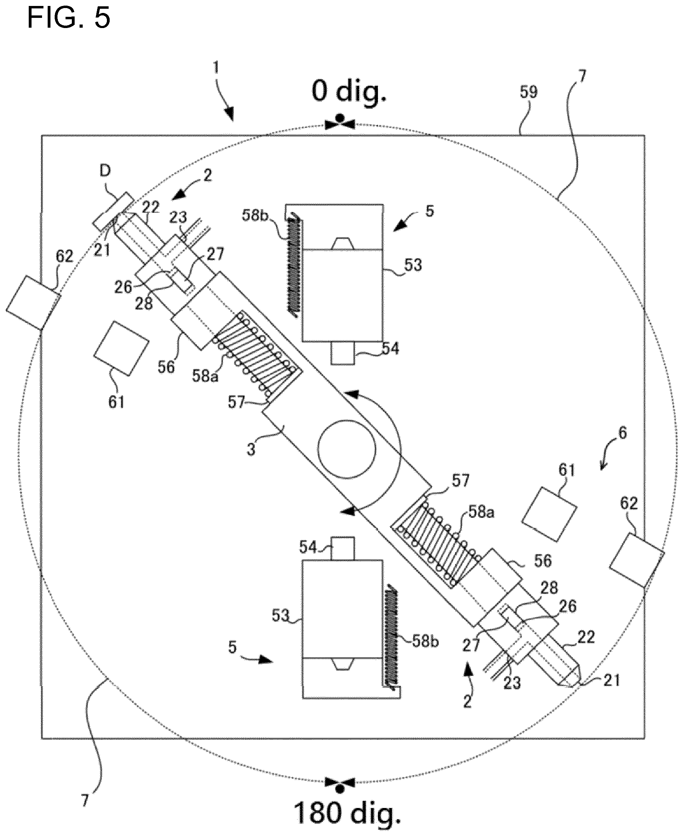

When receiving the electronic component D from the supply unit 140 and transferring the electronic component D to the handler 120, the suction nozzles 2, 2 advance radially outwards of the rotor 3. Additionally, the suction nozzles 2, 2 withdraw towards the center of the rotor 3 after they pick up electronic components D from the supply unit 140 and after they transfer the electronic components D to the handler 120. Due to this, as shown in Figs. 4 and 5, the relay unit 130 includes the reciprocating driving units 5 for reciprocating the suction nozzles 2, 2 in the radial direction.

Slide pushers 53 are placed in an angular position of 0 degree on the relay unit 130 so as to extend directly upwards and in an angular position of 180 degrees on the relay unit 130 so as to extend directly downwards. A rotating motor 51 having a motor shaft which is laid at right angles to a sliding direction of the slide pusher 53 is provided on a rear side of the slide pusher 53 which extends directly upwards so as to extend directly sideways in a horizontal direction. Additionally, a rotating motor 51 having a motor shaft which is laid at right angles to a sliding direction of the slide pusher 53 is provided on a rear side of the slide pusher 53 which extends directly downwards so as to extend directly sideways in a horizontal direction.

Namely, the two sets of slide pushers 53 and rotating motors 51 are aligned along a rotational axis of the rotor 3 and are disposed in a dispersed fashion to so as to lie directly above and directly below the motor 4. Therefore, the reciprocating driving units 5 are disposed without a risk of interfering with each other physically.

Further, the relay unit 130 includes part detection sensors 6 for detecting whether or not an electronic component D is held on the suction nozzle 2 which are provided in a non-stop section 7 which the suction nozzle 2 passes without stopping. In the case where the handler 120 is disposed upper, while the supply unit 140 is disposed lower, and the relay unit 130 is disposed between the handler 120 and the supply unit 140, almost all of a circumference of an imaginary circle drawn by the rotor 3 when rotating excluding the angular position of 0 degree where the suction nozzle 2 is oriented directly upwards and the angular position of 180 degrees where the suction nozzle 2 is oriented directly downwards is defined as the non-stop section 7.

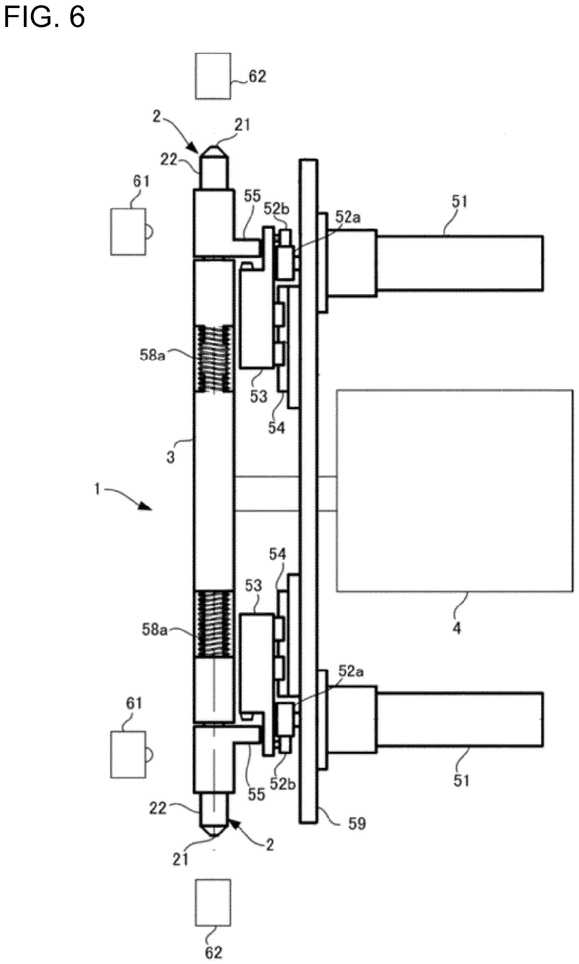

Firstly, the construction of the suction nozzle 2 which faces the part detection sensor 6 will be described. As shown in Figs. 5 and 6, the suction nozzle 2 has as a main body a nozzle portion 22 which is cylindrical and hollow inside. An opening of the nozzle portion 22 which lies radially outwards of the rotor 3 constitutes a suction hole 21, while a rear end of the nozzle portion 22 constitutes a bottom thereof. A vacuum supply port 23 and a side opening 28 are formed in side portions of a main body of the nozzle portion 22. The vacuum supply port 23 communicates with an inside and outside of the nozzle portion 22 and is connected to a vacuum generation device such as a vacuum pump or an ejector which are provided separately from the electronic components moving apparatus 1, a vacuum is supplied into the nozzle portion 22 through the vacuum supply port 23.

The side opening 28 is formed in a position lying on a rear end side of the nozzle portion 22 which lies farther away from the suction hole 21 than the vacuum supply port 23 and communicates with the inside and outside of the nozzle portion 22. A glass plate 26 is fitted in an interior portion of the nozzle portion 22 between the side opening 28 and the vacuum supply port 23. The glass plate 26 is a light transmitting member having a light transmitting function to transmit light and a sealing function to cut off a communication of air. In addition, a reflection plate 27 is fitted in the interior portion of the nozzle portion 22 so as to face the side opening 28. The reflection plate 27 is a light guiding member which reflects light incident thereon in a direction which is at right angles to an open surface of the side opening 28 so as to travel an optical path extending along an axis of the nozzle portion 22. The reflection plate 27 is placed inclined at an angle of 45 degrees relative to the side opening 28.

The part detection sensor 6 placed in the non-stop section 7 is, for example, a laser sensor, a fiber sensor or a photo-interrupter and includes a light projector 61 such as a semiconductor laser or a light emitting diode and a photoreceptor 62 such as a transistor. The photoreceptor 62 is placed within the non-stop section 7 so as to be square to the suction hole 21 of the suction nozzle 2 which passes one point of the non-stop section 7. In other words, the photoreceptor 62 is situated on an extension of a cylindrical axis of the suction nozzle 2 which passes one point of the non-stop section 7. The light projector 61 is disposed on an imaginary orthogonal line to the open surface of the side opening 28 which is formed in the suction nozzle 2 which is situated on one point of the non-stop section 7 so as to be square to the side opening 28 and projects light into the side opening 28.

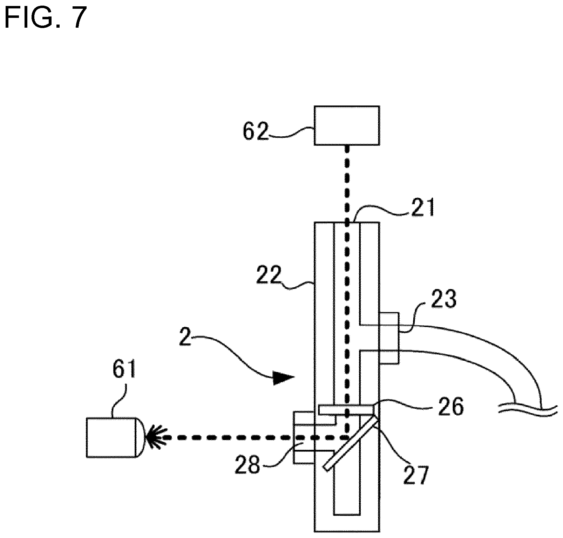

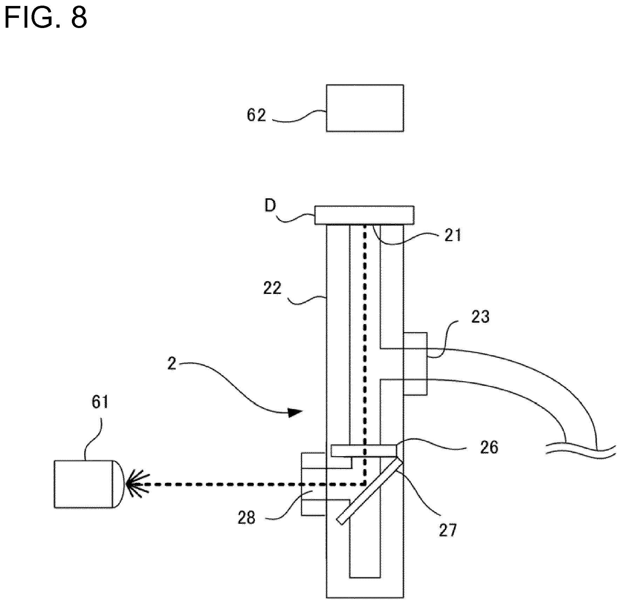

As shown in Fig. 7, in this part detection sensor 6, in case the suction nozzle 2 which is moving to pass one point on the non-stop section 7 holds no electronic component D, detection light of the light projector 61 reaches the photoreceptor 62 via the reflection plate 27. On the other hand, as shown in Fig. 8, in case the suction nozzle 2 which is moving to pass one point on the non-stop section 7 holds an electronic component D, detection light emitted from the light projector 61 and reflected by the reflection plate 27 is interrupted by the electronic component D which closes the suction hole 21 and hence does not reach the photoreceptor 62, whereby the photoreceptor 62 cannot sense the detection light.

The part detection sensor 6 samples a quantity of light which the photoreceptor 62 receives at a timing at which the suction nozzle 2 passes the point where the photoreceptor 62 is placed. In case the quantity of light received by the photoreceptor 62 reaches a quantity of light received which indicates an arrival of the detection light, it can be determined that an electronic component D falls during conveyance or a transfer of an electronic component D fails.

In the electronic components conveyor system 100 configured in the way described heretofore, in the relay unit 130, the motor is driven, whereby the rotor 3 rotates through 180 degrees, and one of the suction nozzles 2 stops while being oriented directly downwards. As this occurs, the suction nozzle 2 which advances radially outwards of the rotor 3 or directly downwards, the slide pusher 53 and the rotating motor 51 are aligned in a line in an exactly horizontal direction which is at right angles to the advancing direction of the suction nozzle 2, and the suction nozzle 2 and the side pusher 53 extend directly downwards in parallel while overlapping each other.

In the reciprocating driving unit 5, the rotating motor 51 is driven, whereby a cylindrical cam 52a moves a cam follower 52b in a direction in which the cam follower 52b moves away from the center, and the slide pusher 53 moves directly downwards along a rail 54 against a biasing force of a tension spring 58b. The slide pusher 53 pushes out a projecting portion 55 which exist in the advancing direction directly downwards, and the suction nozzle 2 including the projecting portion 55 advances directly downwards against a biasing force of a compression spring 58a.

The suction nozzle 2 which is caused to move directly downwards as described above takes out an electronic component D from the supply unit 140 by means of a vacuum and holds it at the suction hole 21. In the reciprocating driving unit 5, when the suction nozzle 2 holds the electronic component D, the rotating motor 51 is driven, whereby the cylindrical cam 52a moves the cam follower 52b towards the center. Then, the slide pusher 53 which loses its thrusting force provided by the cylindrical cam 52a and the cam follower 52b is withdrawn directly upwards along the rail 54 by means of the biasing force of the tension spring 58b. The projecting portion and the slide pusher 53 are caused to move away from each other by the withdrawal of the slide pusher 53, and the suction nozzle 2 which holds the electronic component D is returned directly upwards by the biasing force of the compression spring 58a.

When the suction nozzle 2 which holds the electronic component D is returned towards the center of the rotor 3, the motor 4 of the relay unit 130 is driven to thereby rotate the rotor 3 through 180 degrees. As this occurs, the rotor 3 is easily accelerated since the rotor 3 is light due to only the suction nozzle 2 and the compression spring 58a being mounted on the rotor 3, whereby the suction nozzle 2 rotates at higher speeds to such an extent that the rotor 3 is made light.

The suction nozzle 2 which holds the electronic component D passes the one point within the non-stop section 7 where the part detection sensor 6 is placed while the rotor 3 is rotating through 180 degrees. As this occurs, the light projector 61 of the part detection sensor 6 is emitting detection light towards the side opening portion 28, and the reflection plate 27 within the side opening 28 reflects the detection light towards the interior portion of the nozzle portion 22. The detection light whose optical path is changed towards the interior portion of the nozzle portion 22 is transmitted through the glass plate 26 and then passes through the interior portion of the nozzle portion 22. In case the suction nozzle 2 holds the electronic component D, the detection light is interrupted by the electronic component D, whereby the detection light cannot be emitted from the suction nozzle 2. As a result of this, the photoreceptor 62 receives no detection light, and the part detection sensor 6 determines that the electronic component D remains held on the suction nozzle 2 without falling due to the fact that no detection light is received by the photoreceptor 62.

On the other hand, in case the electronic component D falls from the suction nozzle 2, the detection light which passes through the interior portion of the nozzle portion 22 can be emitted from the suction hole 21 to reach the photoreceptor 62. The photoreceptor 62 detects the detection light, and the part detection sensor 6 determines that the electronic component D has fallen from the suction nozzle 2.

When the suction nozzle 2 which holds the electronic component D stops while being oriented directly upwards, the suction nozzle 2 which advances directly upwards or radially outwards of the rotor 3, the slide pusher 53 and the rotating motor 51 are aligned in a line in an exactly horizontal direction which is at right angles to the advancing direction of the suction nozzle 2, and the suction nozzle 2 and the side pusher 53 extend directly upwards in parallel while overlapping each other.

The reciprocating driving unit 5 configured to reciprocate the suction nozzle 2 which is oriented directly upwards moves the suction nozzle 2 which holds the electronic component D directly upwards. The suction nozzle 123 of the handler 120 picks up the electronic component D from the suction nozzle 2 which has advanced towards the suction nozzle 123 while holding the electronic component D. When the electronic component D has been transferred in the way described above, the suction nozzle 2 on the relay unit 130 is withdrawn by the reciprocating driving unit 5 so as to move directly downwards to return to its initial state and restarts its routine operation of picking up an electronic component D from the supply unit 140.

The handler 120 which receives the electronic component D from the relay unit 130 moves intermittently the electronic component D along the conveying path 101, so that the processing units 110 perform predetermined required operations on the electronic component D. The electronic component D which has moved all the way around the processing units 110 is eventually contained in the container unit 150.

When the part detection sensor 6 determines that the electronic component D has fallen, it thus follows that the suction nozzle 123 of the handler 120 which is expected to receive the electronic component D is moving with no electronic component D held thereby. Therefore, in the electronic components conveyor system 100, even though the suction nozzle 123 in question arrives at the processing units 110, the reciprocating driving units 124 and the processing units 110 are kept inoperable. In addition, in case the container unit 150 constitutes a tray shifting unit, even though the suction nozzle 123 with no electronic component D held thereby arrives at the container unit 150 in question, the container unit 150 does not perform a tray shifting operation of causing an empty pocket to face the suction nozzle 123. Additionally, for example, when a determination that the electronic part D has fallen is made, the electronic components conveyor system 100 is stopped.

In this way, a number of reciprocating driving units 5 can be disposed on the relay unit 130 on which the suction nozzles 2 are provided so as to extend in the radial direction by applying the electronic components moving apparatus 1 to the relay unit 130 of the electronic components conveyor system 100. This enables the relay unit 130 whose main role is to relay electronic components D between the handler 120 and the supply unit 140 to perform other processing operations thereon such as a visual inspection for external appearance of an electronic component D, a correction of positional deviation of an electronic component D and the like. Namely, the electronic components moving apparatus 1 is allowed to perform a multiplicity of functions effectively while maintaining the high speed conveying capability of the electronic components conveyor system 100.

In this application example, the side opening 28, the glass plate 26 and the reflection plate 27 are provided as the light guiding port for the part detection sensor 6, the light transmitting member and the light guiding member, respectively. However, as long as the light transmitting function, the sealing up function and the light guiding function are provided, other optical parts can be used in place of the glass plate 26 and the reflection plate 27. The guiding port should not reduce a vacuum transmitted to the suction hole 21 or should not interrupt the transmission of a vacuum to the suction hole 21, and hence, the guiding port does not have to be formed at the rear end of the nozzle portion 22, provided that the guiding port is formed in a position which lies farther away from the suction hole 21 than the vacuum supply port 23. Additionally, the light guiding member may be disposed anywhere including the position of the light guiding port, provided that the light guiding member is situated closer to the light guiding port than the vacuum supply port 23.

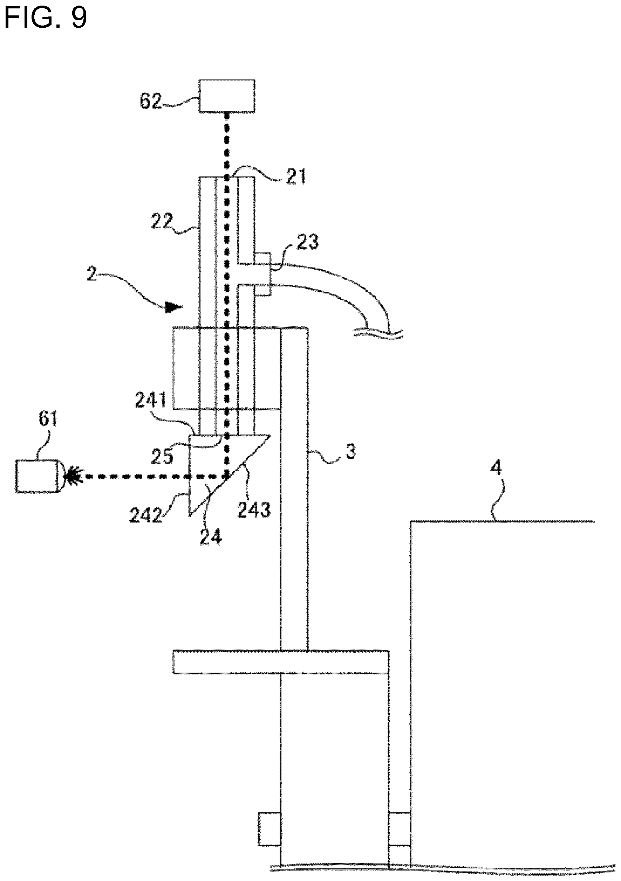

Typically, as shown in Fig. 9, a configuration may be adopted in which a rear end opening 25 is formed in the nozzle portion 22, that is, a cylindrical end portion of the nozzle portion 22 which is situated opposite to the suction hole 21 is opened, and a triangular prism 24 is placed so as to close the rear end opening 25. The triangular prism 24 is disposed so that the rear end opening 25 is closed by a square surface 241 of a pair of square surfaces of the triangular prism 24 and when the suction nozzle 2 arrives at the position where the part detection sensor 6 is placed, the other square surface 242 becomes square to the light projector 61.

Detection light output from the light projector 61 is incident on the square surface 242 at right angles and is then reflected in the direction of the interior portion of the nozzle portion 22 by an inclined surface 243. Then, the detection light is transmitted through the square surface 241 and passes through the interior portion of the nozzle portion 22. In this way, with the triangular prism 24, one optical part includes the light transmitting function, the sealing up function and the light guiding function, and the square surface 241 which closes the rear end opening 25 constitutes a light transmitting member, and the inclined surface 243 constitutes a light guiding member.

In addition, the side opening 28 may be closed by the glass plate 26, and the triangular prism 24 may be placed in the interior portion of the nozzle portion 22 so as to face the side opening 28. Alternatively, a transparent acrylic plate may be used in place of the glass plate 26 as the light emitting member.

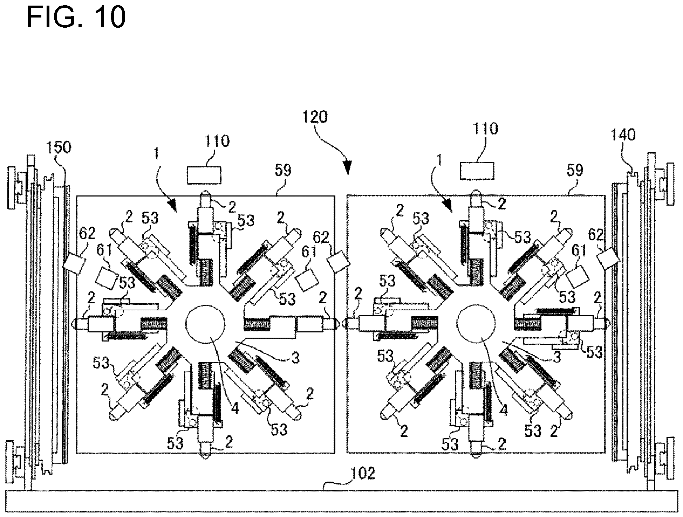

As shown in Fig. 10, an electronic components conveyor system 100 according to a second application example includes processing units 110, a handler 120 and a supply unit 140. The handler 120 is the electronic components moving apparatus 1 and includes conjunctively two vertically placed rotors 3. The supply unit 140 is disposed on a circumference of one rotor 3, and a container unit 150 is disposed on a circumference of the other rotor 3. The various processing units 110 are disposed on the circumferences of the two rotors 3 in a dispersed fashion.

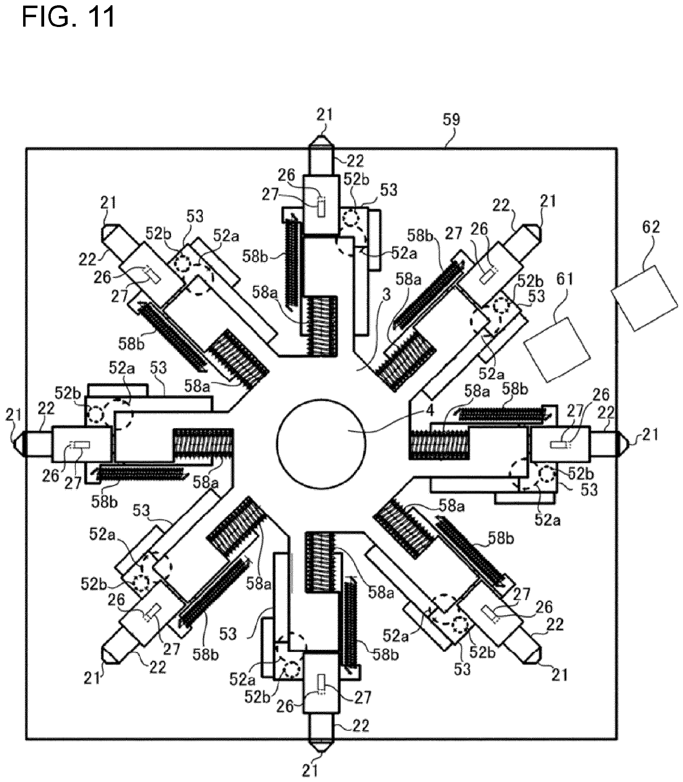

As shown in Fig. 11, each rotor 3 has a star shape or a circular disc shape in which arms are arranged radially. The rotor 3 is supported rotatably at a circle center thereof by a rotational shaft of a motor 4 and is rotated intermittently in a circumferential direction by the motor 4. This rotor 3 is disposed vertically so that a plane where the rotor 3 expands and a plane where a base 102 expands are at right angles to each other. In other words, this rotor 3 is disposed vertically so that a motor shaft of the motor 4 and the plane of the base 102 extend parallel to each other.

Suction nozzles 2 are placed at tips of the arms or in positions arranged at equal intervals along a circular disc-shaped outer circumference. The suction nozzles 2 are disposed so that cylindrical axes of the suction nozzles 2 follow a radial direction of the rotor 3 and project radially outwards of the rotor 3, and suction holes 21 are oriented outwards of the rotor 3. The tips of the suction nozzles 2 are situated on the same circular traveling path which is concentric with the rotor 3. A rotational angle of the rotor 3 when the rotor 3 is rotated by the motor 4 each time is the same as the angular interval at which the suction nozzles 2 are disposed. The suction nozzles 2 stop in common stopping positions which result from dividing the whole circumference of the rotor 3 by the number of suction nozzles 2. The suction nozzles 2 are controlled to stop in a position where the two rotors 3 come closest to each other.

The supply unit 140, the various processing units 110 and the container unit 150 are disposed in the stopping positions of the suction nozzles 2, and reciprocating driving units 5 are placed in the positions where the two adjacent rotors 3 come closest to each other and where the supply unit 140, the processing units 110 and the container unit 150 are disposed. When the suction nozzles 2 arrive at the positions where the reciprocating driving units 5 are placed, the suction nozzle 2, a slide pusher 53 and a rotating motor 51 are aligned in a line along a rotational axis of the rotor 3.

The reciprocating driving units 5 are placed in all the stopping positions where the suction nozzles 2 stop on the rotor 3 which is adjacent to the supply unit 140. However, no reciprocating driving unit 5 may be placed at a location where the processing unit 110 is placed which does not require the suction nozzle 2 to reciprocate. This processing unit 110 is, for example, a camera unit for detecting a positional deviation of an electronic component D by capturing an image of the electronic component D. In addition, in the handler 120 including the two rotors 3 placed side by side, a reciprocating driving unit 5 is provided at a point where the two adjacent rotors 3 come closest to each other, although no processing unit 110 is placed, so as to reciprocate one of the two facing suction nozzles 2 to the other. However, on the rotor 3 which lies closest to the supply unit 140, a reciprocating driving unit 5 is placed in the stopping position which lies closest to the rotor 3 which lies closest to the container unit 150, whereas on the rotor 3 which lies closest to the container unit 150, no reciprocating driving unit 5 is provided in the stopping position which lies closest to the rotor 3 which lies closest to the supply unit 140.

Sections defined between the stopping positions of the suction nozzles 2 constitute non-stop sections 7, and a part detection sensor 6 is provided within at least one of the non-stop sections 7. There is a great risk of an electronic component D falling from the suction nozzle 2 when one of the rotors 3 receives an electronic component D from the supply unit 140, the electronic component D is transferred between the two rotors 3, and the electronic component D is transferred to the container unit 150 by the other rotor 3. Consequently, the part detection sensor 6 should be placed in a first non-stop section 7 starting from the supply unit 140, a first non-stop section 7 starting from the reception of the electronic component D by the rotor 3 to which the electronic component D is transferred from the adjacent rotor 3, and a last non-stop section 7 which ends at the container unit 150.

In the electronic components conveyor system 100 according to the second application example, one of the rotors 3 is rotated by the motor 4, and one suction nozzle 2 faces the supply unit 140. The reciprocating driving unit 5 which is disposed in the stopping position of the suction nozzle 2 causes the suction nozzle 2 to advance towards the supply unit 140, and the suction nozzle 2 receives an electronic component D from the supply unit 140.

When the suction nozzle 2 receives the electronic component D, the rotor 3 is rotated by the motor 4 which constitutes a drive source, and the suction nozzle 2 holding the electronic component D moves through the non-stop section 7 where the part detection sensor 6 is disposed to pass one point in the non-stop section 7. As this occurs, the part detection sensor 6 determines whether or not the electronic component D has fallen from suction nozzle 2 or the suction nozzle 2 fails to receive the electronic component D. In the event that the electronic component D has fallen from the suction nozzle 2 or the suction nozzle 2 fails to receive the electronic component D, the electronic components conveyor system 100 operates in such a way that the suction nozzle 2 holds no electronic component D.

When the suction nozzle 2 holding the electronic component D comes to be positioned at the point where the two rotors 3 lie closest to each other by way of the processing unit 100, one of the suction nozzles 2 of the two rotors 3 which face each other is advanced towards the other suction nozzle 2 by the reciprocating driving unit 5, whereby the electronic component D is transferred between the two suction nozzles 2. The part detection sensor 6 is disposed at one point within the first non-stop section 7 starting from the transfer of the electronic component D to the rotor 3 on the side of the container unit 150.

When the suction nozzle 2 which receives the electronic component D from the rotor 3 on the side of the supply unit 140 passes the one point in the non-stop section 7, the part detection sensor 6 determines whether or not the electronic component has fallen from the suction nozzle 2 or the suction nozzle fails to receive the electronic D. In the event that the electronic component D has fallen from the suction nozzle 2 or the suction nozzle 2 fails to receive the electronic component D, the electronic components conveyor system 100 operates in such a way that the suction nozzle 2 holds no electronic component D.

Further, when the suction nozzle 2 holding the electronic component D arrives at a position where the suction nozzle 2 faces the container unit 150 by way of the processing unit 110, the reciprocating driving unit 5 which is disposed in the stopping position of the suction nozzle 2 causes the suction nozzle 2 to advance to the container unit 150, whereby the suction nozzle 2 transfers the electronic component D to the container unit 150.

In the electronic components conveyor system 100 configured in the way described heretofore, the handler 120 can be made up of one or more rotors 3, and the rotors 3 may be disposed vertically or horizontally. Alternatively, the handler 120 may include one vertically disposed rotor and one horizontally disposed rotor 3 which are arranged to be closest to each other.

### (Other Embodiments)

While the embodiments of the invention have been described heretofore, various omissions, replacements and modifications can be made thereto without departing from the scope of the invention which is defined by the claims.

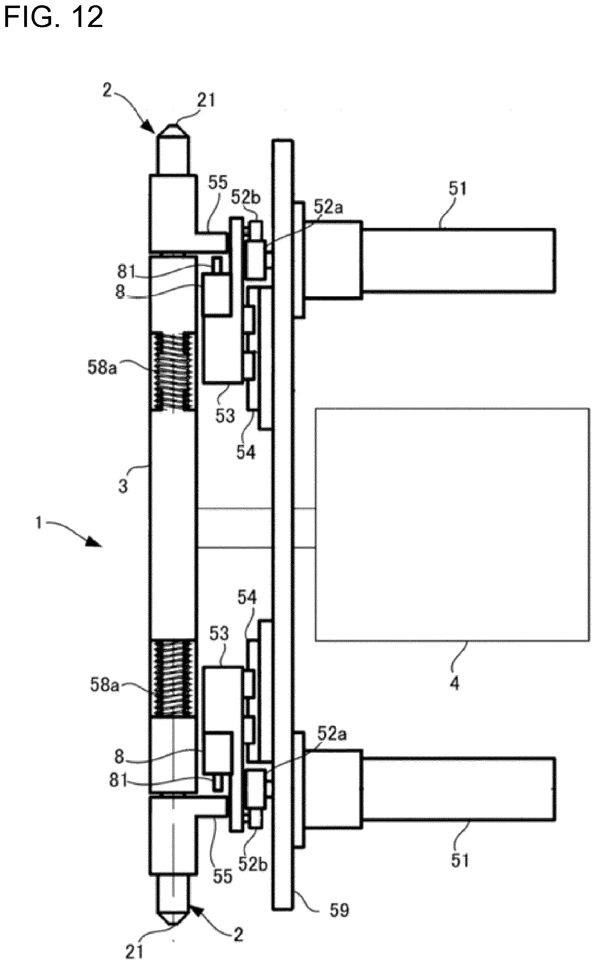

For example, as shown in Fig. 12, a voice coil motor 8 may be disposed on a slide pusher 53. The voice coil motor 8 includes a rod 81 which advances or withdraws in an axial direction. The voice coil motor 8 is placed at a tip of the slide pusher 53, and an end portion of the rod 81 is oriented towards a projecting portion 55 of a suction nozzle 2. In the slide pusher 53, the rod 81 of the voice coil motor 8 constitutes an abutment portion with the projecting portion 55 of the suction nozzle 2.

A rotating motor 51 constitutes a drive source for moving the suction nozzle 2 via the slide pusher 53, whereas a voice coil motor 8 of a reciprocating driving unit 5 which is placed at a point lying closest to an adjacent rotor 3 constitutes a drive source for controlling a load exerted on an electronic component D which is held between two facing suction nozzles 2 therebetween. In addition, a voice coil motor 8 of a reciprocating driving unit 5 which is placed so as to face a processing unit 110 constitutes a drive source for controlling a load exerted on an electronic component D which is held by the suction nozzle 2 and the processing unit 110 therebetween.

When the rotating motor 51 is driven, the slide pusher 53 is brought into abutment with the projecting portion 55 of the suction nozzle 2 at the rod 81. After the abutment, the voice coil motor 8 generates an opposite thrusting force which is equal to a resisting force borne from the suction nozzle 2 while the slide pusher 53 is advancing to push out the suction nozzle 2 and prevents a withdrawal of the rod 81.

When an electronic component D is transferred from one of the two facing suction nozzles 2 to the other, it is desirable that a load approximating to zero is exerted on the electronic component D which is held between the suction nozzle 2 which is pushed out by the slide pusher 53 and the suction nozzle 2 which is waiting for a transfer. The voice coil motor 8 causes a thrusting force to approximate to zero to allow the rod 81 to withdraw so that a load exerted on the electronic component D can be absorbed.

In addition, when the electronic component D is pushed on the processing unit 110, it is desirable that a desired load is exerted on the electronic component D which is held between the suction nozzle 2 which is pushed out by the slide pusher 53 and the processing unit 110 which waits for a transfer. The voice coil motor 8 applies a thrusting force equal to the load exerted on the electronic component D to the rod 81.

By doing so, the load exerted on the electronic component D can be controlled to a desired value including zero, while the suction nozzle 2, the slide pusher 53 and the rotating motor 51 are disposed so that they are aligned in a line substantially along a rotational axis of the rotor 3 when the suction nozzle 2 stops in the position where the reciprocating driving unit 5 is placed.

### Description of Reference Numerals and Character

1 Electronic components moving apparatus; 2 Suction nozzle; 21 Suction hole; 22 Nozzle portion; 23 Vacuum supply port; 24 Triangular prism; 241 First square surface; 242 Second square surface; 243 Inclined surface; 25 Rear end opening; 26 Glass plate; 27 Reflection plate; 28 Side opening; 3 Rotor; 4 Motor; 5 Reciprocating driving unit; 51 Rotating motor; 52a Cylindrical cam; 52b Cam follower; 53 Slide pusher; 54 Rail; 55 Projecting portion; 56 Sleeve; 57 Flange; 58a Compression spring; 58b Tension spring; 59 Motor flange; 6 Part detection sensor; 61 Light projector; 62 Photoreceptor; 7 Non-stop section; 8 Voice coil motor; 81 Rod; 100 Electronic components conveyor system; 101 Conveying path; 102 Base; 110 Processing unit; 120 Handler; 121 Turret table; 122 Direct drive motor; 123 Suction nozzle; 124 Reciprocating driving unit; 124a Electric motor; 124b Rod; 130 Relay unit; 140 Supply unit; 150 Container unit; D Electronic component.

## Claims

1. An electronic components moving apparatus comprising:
a holding portion (2) for holding an electronic component (D) at a tip thereof;
a rotor (3) on which the holding portion (2) is disposed around a rotational axis with the tip of the holding portion (2) oriented radially outwards and which intermittently rotates the holding portion (2) about the rotational axis through a predetermined angle each time;
a reciprocating driving portion (5) which is set in at least one of stopping positions of the holding portion (2) to advance the holding portion (2) radially outwards of the rotor (3); and
a projecting portion (55) which projects from the holding portion (2),
**characterized in that**
the reciprocating driving portion (5) includes:
a slide pusher (53) which is placed so as to slide radially outwards of the rotor (3) on a rail (54) and which is configured to be brought into abutment with the projecting portion (55) to push out the holding portion (2); and
a reciprocating driving motor (51) which is a drive source of the slide pusher (53), and
wherein the slide pusher (53) and the reciprocating driving motor (51) are arranged so that the holding portion (2), the slide pusher (53) and the reciprocating driving motor (51) are aligned along a direction which is substantially perpendicular to a rotational plane of the rotor (3), when the holding portion (2) stops in a position where the reciprocating driving portion (5) is placed, wherein the rail (54) is disposed on an inner side of the reciprocating driving motor (51) in a radial direction of the rotor (3).

2. The electronic components moving apparatus according to Claim 1,
wherein the holding portion (2) includes the projecting portion (55) which projects from a side portion of a main body thereof, and
wherein the slide pusher (53) has a radially outward tip which is arranged closer to a central side of the rotor (3) than the projecting portion (55), and the slide pusher (53) is disposed so as to overlap the holding portion (2) when the holding portion (2) stops in the position where the reciprocating driving portion (5) is placed.

3. The electronic components moving apparatus according to Claim 1 or 2,
wherein the slide pusher (53) is placed so as to move parallel to an advancing direction of the holding portion (2),
wherein the reciprocating driving motor (51) has a motor shaft which is perpendicular to a moving direction of the slide pusher (53), and
wherein a cam mechanism (52a, 52b) is provided so as to be interposed between the slide pusher (53) and the reciprocating driving motor (51) to convert a rotational thrusting force of the reciprocating driving motor (51) into a rectilinear thrusting force acting in the moving direction of the slide pusher (53).

4. The electronic components moving apparatus according to any one of Claims 1 to 3, wherein the reciprocating driving portion (5) includes:
a spring member (58a, 58b) for accumulating a biasing force with which the holding portion (2) and the slide pusher (53) are returned in the direction of a center of the rotor (3), and
wherein the slide pusher (53) pushes out the holding portion (2) outwards of the rotor (3) against the biasing force of the spring member (58a).

5. The electronic components moving apparatus according to any one of Claims 1 to 4, comprising:
a rotating motor (4) which pivotally supports the center of the rotor (3) by a motor shaft thereof and which is configured to intermittently rotate the rotor (3); and
a base plate which is interposed to expand between the rotor (3) and the rotating motor (4),
wherein the reciprocating driving motor (51) is fixed to a surface of the base plate where the rotating motor (4) is attached, and
wherein the slide pusher (53) is placed on a surface of the base plate at a side of the rotor (3).

6. The electronic components moving apparatus according to Claim 5,
wherein the slide pusher (53) is disposed so that the slide pusher (53) places directly behind the holding portion (2), that is, a side of the holding portion (2) which faces a motor flange (59) or is disposed so as to deviate in a radial direction or a tangential direction of the rotor (3) or a direction which is parallel to the rotational plane of the rotor (3) and which intersects obliquely the radial direction directly on a rear side of the holding portion (2), when the holding portion (2) stops in the position where the reciprocating driving portion (5) is placed, and
wherein the reciprocating driving motor (51) is disposed directly behind the holding portion (2), that is, the side of the holding portion (2) which faces the motor flange (59) or is disposed so as to deviate in the radial direction or the tangential direction of the rotor (3) or the direction which is parallel to the rotational plane of the rotor (3) and which intersects obliquely the radial direction directly on the rear side of the holding portion (2).

7. The electronic components moving apparatus according to any one of Claims 1 to 6,
wherein the rotor (3) includes a plurality of holding portions (2) and stops the holding portions (2) in angular positions which result from dividing a whole circumference of the rotor (3) by the number of holding portions (2), and
wherein reciprocating driving portions (5) are disposed in all stopping positions of the holding portions (2).

8. The electronic components moving apparatus according to any one of Claims 1 to 7,
wherein the slide pusher (53) includes a voice coil motor (8) which is placed radially outwards of the rotor (3) with its rod (81) oriented towards the projecting portion (55), and
wherein the voice coil motor (8) pushes out the holding portion (2) by a slide of the slide pusher (53) and controls a load exerted on the electronic component (D) by means of a thrusting force of the rod (81).

9. An electronic components conveyor system which comprises the electronic components moving apparatus according to any one of Claims 1 to 8, and which is configured to apply various processing operations to the electronic components (D) while conveying them in a line.

10. The electronic components conveyor system according to Claim 9, comprising:
a supply unit (140) for containing the electronic components (D) to which the various processing operations are applied;
a handler (120) for conveying the electronic components (D) in the supply unit (140) in a line along an annular conveying path (101);
various types of processing units (110) which are disposed along the conveying path (101); and
a container unit (150) for containing the electronic components (D) which have been conveyed by the handler (120),
wherein the electronic components moving apparatus is disposed between the supply unit (140) and the conveying path (101) as a relay unit (130) which picks up the electronic component (D) in the supply unit (140) to pass it on to the handler (120).

11. The electronic components conveyor system according to Claim 9, comprising:
a supply unit (140) for containing the electronic components (D) to which the various processing operations are applied;
a handler (120) for conveying the electronic components (D) in the supply unit (140) in a line along an annular conveying path (101);
various types of processing units (110) which are disposed along the conveying path (101); and
a container unit (150) for containing the electronic components (D) which have been conveyed by the handler (120),
wherein a plurality of electronic components moving apparatuses are disposed in succession as the handler (120).

12. The electronic components moving apparatus according to any one of Claims 1 to 7, wherein one of the slide pusher (53) and the reciprocating driving motor (51) has an area which is greater than an area of the other one of the slide pusher (53) and the reciprocating driving motor (51) when seen from a direction which is perpendicular to the rotational plane of the rotor (3), and
wherein the area of the other one of the slide pusher (53) and the reciprocating driving motor (51) is contained in the area of the one of the slide pusher (53) and the reciprocating driving motor (51) when seen from the direction which is perpendicular to the rotational plane of the rotor (3).

## Patentansprüche

1. Bewegungsvorrichtung für elektronische Komponenten (D), aufweisend:
eine Halteeinheit (2), zum Halten einer elektronischen Komponente (D) an einer Spitze der Halteeinheit (2);
einen Rotor (3), auf dem die Halteeinheit (2) um eine Rotationsachse herum angeordnet ist, wobei die Spitze der Halteeinheit (2) radial nach außen ausgerichtet ist, und der die Halteeinheit (2) intermittierend um die Rotationsachse rotiert, und zwar jeweils über einen vorgegebenen Winkelbereich;
eine Reziprokantriebseinheit (5), welche in mindestens einer der Anhaltepositionen der Halteeinheit (2) angeordnet ist, um die Halteeinheit (2) in radialer Richtung des Rotors (3) nach außen vorwärtszubewegen; und
einen Fortsatzbereich (55), welcher von der Halteeinheit (2) aus vorspringt, **dadurch gekennzeichnet, dass**
die Reziprokantriebseinheit (5) aufweist:
einen Gleitschieber (53), der so angeordnet ist, dass er auf einer Schiene (54) in einer Radialrichtung des Rotors (3) nach außen gleiten kann, und der dazu vorgesehen ist, mit dem Fortsatzbereich (55) in Anschlag gebracht zu werden, um so die Halteeinheit (2) herauszuschieben; und
einen Reziprokantriebsmotor (51), der eine Antriebsquelle des Gleitschiebers (53) darstellt,
wobei der Gleitschieber (53) und der Reziprokantriebsmotor (51) derart angeordnet sind, dass die Halteeinheit (2), der Gleitschieber (53) und der Reziprokantriebsmotor (51) entlang einer zu einer Rotationsebene des Rotors (3) im Wesentlichen senkrechten Richtung ausgerichtet sind, wenn die Halteeinheit (2) in einer Position anhält, in der die Reziprokantriebseinheit (5) angeordnet ist,
wobei die Schiene (54) in einer Radialrichtung des Rotors (3) auf einer Innenseite des Reziprokantriebsmotors (51) angeordnet ist.

2. Bewegungsvorrichtung für elektronische Komponenten (D) nach Anspruch 1,
wobei die Halteeinheit (2) den Fortsatzbereich (55) aufweist, der von einem seitlichen Bereich eines Grundkörpers der Halteeinheit (2) aus vorspringt, und
wobei der Gleitschieber (53) eine radial nach außen gerichtete Spitze aufweist, welche näher an einer mittigen Seite des Rotors (3) angeordnet ist als der Fortsatzbereich (55),
und der Gleitschieber (53) so angeordnet ist, dass er die Halteeinheit (2) überlappt, wenn die Halteeinheit (2) in der Position anhält, in der die Reziprokantriebseinheit (5) angeordnet ist.

3. Bewegungsvorrichtung für elektronische Komponenten (D) nach Anspruch 1 oder 2,
wobei der Gleitschieber (53) so angeordnet ist, dass er sich parallel zu einer Vorschubrichtung der Halteeinheit (2) bewegt,
wobei der Reziprokantriebsmotor (51) eine zu einer Bewegungsrichtung des Gleitschiebers (53) parallele Motorwelle aufweist, und
wobei ein Kurvengetriebe (52a, 52b) so eingerichtet ist, dass es zwischen dem Gleitschieber (53) und dem Reziprokantriebsmotor (51) angeordnet ist, um eine Rotationsvorschubkraft des Reziprokantriebsmotors (51) in eine in der Bewegungsrichtung des Gleitschiebers (53) wirkende Linearvorschubkraft umzuwandeln.

4. Bewegungsvorrichtung für elektronische Komponenten (D) nach einem der Ansprüche 1 bis 3, wobei die Reziprokantriebseinheit (5) aufweist:
ein Federelement (58a, 58b) zum Speichern einer Vorspannkraft, mit welcher die Halteeinheit (2) und der Gleitschieber (53) in Richtung eines Zentrums des Rotors (3) zurückbewegt werden,
wobei der Gleitschieber (53) die Halteeinheit (2) gegen die Vorspannkraft des Federelements (58a) nach außerhalb des Rotors (3) schiebt.

5. Bewegungsvorrichtung für elektronische Komponenten (D) nach einem der Ansprüche 1 bis 4, aufweisend:
einen Rotationsmotor (4), welcher das Zentrum des Rotors (3) durch eine Motorwelle desselben schwenkbar lagert und welcher dazu vorgesehen ist, den Rotor (3) intermittierend zu rotieren; sowie
eine Grundplatte, welche zwischen dem Rotor (3) und dem Rotationsmotor (4) angeordnet und dazu eingerichtet ist, sich zwischen dem Rotor (3) und dem Rotationsmotor (4) zu erstrecken,
wobei der Reziprokantriebsmotor (51) auf einer Oberfläche der Grundplatte dort befestigt ist, wo der Rotationsmotor (4) angebracht ist, und
wobei der Gleitschieber (53) auf einer Oberfläche der Grundplatte seitlich des Rotors (3) angeordnet ist.

6. Bewegungsvorrichtung für elektronische Komponenten (D) nach Anspruch 5,
wobei der Gleitschieber (53) derart angeordnet ist, dass der Gleitschieber (53) sich unmittelbar hinter der Halteeinheit (2) befindet, d. h. an einer einem Motorflansch (59) zugewandten Seite der Halteeinheit (2), oder so angeordnet ist, dass er in Radialrichtung oder Tangentialrichtung des Rotors (3) davon abweicht, oder in einer zu der Rotationsebene des Rotors (3) parallelen Richtung, welche die Radialrichtung unmittelbar auf einer Rückseite der Halteeinheit (2) schräg schneidet, wenn die Halteeinheit (2) in der Position anhält, in welcher die Reziprokantriebseinheit (5) sich befindet, und
wobei der Reziprokantriebsmotor (51) direkt hinter der Halteeinheit (2) angeordnet ist, d. h. auf der dem Motorflansch (59) zugewandten Seite der Halteeinheit (2), oder so angeordnet ist, dass er davon abweicht in Radialrichtung oder Tangentialrichtung des Rotors (3) oder in der zu der Rotationsebene des Rotors (3) parallelen Richtung, die die Radialrichtung unmittelbar auf einer Rückseite der Halteeinheit (2) schräg schneidet.

7. Bewegungsvorrichtung für elektronische Komponenten (D) nach einem der Ansprüche 1 bis 6,
wobei der Rotor (3) eine Vielzahl von Halteeinheiten (2) aufweist und die Halteeinheiten (2) in Winkelpositionen anhält, welche sich aus einer Division des Gesamtumfangs des Rotors (3) durch die Anzahl der Halteeinheiten (2) ergeben, und
wobei in allen Anhaltepositionen der Halteeinheiten (2) Reziprokantriebseinheiten (5) angeordnet sind.

8. Bewegungsvorrichtung für elektronische Komponenten (D) nach einem der Ansprüche 1 bis 7,
wobei der Gleitschieber (53) einen Schwingspulenmotor (8) aufweist, welcher in einem radial äußeren Bereich des Rotors (3) so angeordnet ist, dass sein Stift (81) in Richtung des Fortsatzbereichs (55) ausgerichtet ist, und
wobei der Schwingspulenmotor (8) die Halteeinheit (2) durch ein Gleiten des Gleitschiebers (53) herausschiebt und eine auf die elektronische Komponente (D) wirkende Last mittels einer Vorschubkraft des Stifts (81) steuert.

9. Fördersystem für elektronische Komponenten (D),
welches die Bewegungsvorrichtung für elektronische Komponenten (D) nach einem der Ansprüche 1 bis 8 aufweist und
welches dazu vorgesehen ist, verschiedene Bearbeitungsoperationen an den elektronischen Komponenten (D) auszuführen, während es sie in einer Reihenfolge transportiert.

10. Fördersystem für elektronische Komponenten (D) nach Anspruch 9, aufweisend:
eine Zuliefereinheit (140) zu einer Unterbringung der elektronischen Komponenten (D), an denen die verschiedenen Bearbeitungsoperationen ausgeführt werden;
eine Handhabungseinheit (120) zu einer Förderung der elektronischen Komponenten (D) in der Zuliefereinheit (140) in einer Reihenfolge entlang eines ringförmigen Förderwegs (101);
verschiedene Typen von Bearbeitungseinheiten (110), welche entlang des Förderwegs (101) positioniert sind; und
eine Behältereinheit (150) zur Unterbringung derjenigen elektronischen Komponenten (D), welche durch die Handhabungseinheit (120) gefördert worden sind,
wobei die Bewegungsvorrichtung für elektronische Komponenten (D) zwischen der Zuliefereinheit (140) und dem Förderweg (101) als Relaiseinheit (130) angeordnet ist, welche die elektronische Komponente (D) in der Zuliefereinheit (140) aufnimmt und an die Handhabungseinheit (120) weiterreicht.

11. Fördersystem für elektronische Komponenten (D) nach Anspruch 9, aufweisend:
eine Zuliefereinheit (140) zu einer Unterbringung derjenigen elektronischen Komponenten (D), an denen die verschiedenen Bearbeitungsoperationen ausgeführt werden;
eine Handhabungseinheit (120) zu einer Förderung der elektronischen Komponenten (D) in der Zuliefereinheit (140) in einer Reihenfolge entlang eines ringförmigen Förderwegs (101);
verschiedene Typen von Bearbeitungseinheiten (110), welche entlang des Förderwegs (101) positioniert sind; und
eine Behältereinheit (150) zur Unterbringung derjenigen elektronischen Komponenten (D), welche durch die Handhabungseinheit (120) gefördert worden sind,
wobei eine in einer Reihenfolge angeordnete Vielzahl von Bewegungsvorrichtungen für elektronische Komponenten (D) die Handhabungseinheit (120) darstellt.

12. Bewegungsvorrichtung für elektronische Komponenten (D) nach einem der Ansprüche 1 bis 7,
wobei, betrachtet in einer zu der Rotationsebene des Rotors (3) senkrechten Richtung, einer von dem Gleitschieber (53) und dem Reziprokantriebsmotor (51) eine Fläche aufweist, die größer ist als eine Fläche des anderen von dem Gleitschieber (53) und dem Reziprokantriebsmotor (51), und
wobei, betrachtet in der zu der Rotationsebene des Rotors (3) senkrechten Richtung, die Fläche des anderen von dem Gleitschieber (53) und dem Reziprokantriebsmotor (51) in der Fläche des einen von dem Gleitschieber (53) und dem Reziprokantriebsmotor (51) enthalten ist.

## Revendications

1. Dispositif de déplacement de composants électroniques (D), comprenant :
une unité de maintien (2) pour retenir un composant électronique (D) sur une pointe de celle-ci ;
un rotor (3),
sur lequel l'unité de maintien (2) est disposée autour d'un axe rotatif, la pointe de l'unité de maintien (2) étant orientée radialement vers l'extérieure,
et qui d'une manière intermittente chaque fois tourne l'unité de maintien (2) autour de l'axe rotatif à travers un angle prédéterminé ;
une unité d'entraînement réciproque (5) disposée dans au moins une de positions d'arrêt de l'unité de maintien (2) pour avancer l'unité de maintien (2) vers l'extérieur dans une direction radiale du rotor (3) ; et
une partie saillante (55) qui saille de l'unité de maintien (2),
**caractérisé en ce que**
l'unité d'entraînement réciproque (5) inclut :
un pousseur glissant (53) qui est disposé de manière à glisser vers l'extérieur dans une direction radiale du rotor (3) sur un rail (54) et qui est configuré à être mis en butée avec la partie saillante (55) pour pousser l'unité de maintien (2) à l'extérieur ; et
un moteur d'entraînement réciproque (51) qui est une source d'entraînement du pousseur glissant (53),
où le pousseur glissant (53) et le moteur d'entraînement réciproque (51) sont agencés d'une telle manière que l'unité de maintien (2), le pousseur glissant (53) et le moteur d'entraînement réciproque (51) soient alignés le long d'une direction qui est sensiblement perpendiculaire à un plan rotatif du rotor (3) si l'unité de maintien (2) s'arrête dans une position où l'unité d'entraînement réciproque (5) est située,
le rail (54) étant disposé sur une face intérieure du moteur d'entraînement réciproque (51) dans une direction radiale du rotor (3).

2. Dispositif de déplacement de composants électroniques (D) selon la revendication 1,
où l'unité de maintien (2) inclut la partie saillante (55) qui saille d'une partie latérale d'un corps de base de ladite unité de maintien (2), et
où le pousseur glissant (53) comporte une pointe orientée radialement à l'extérieur, qui est agencée plus près d'une face centrale du rotor (3) que la partie saillante (55),
et le pousseur glissant (51) est disposé d'une telle manière qu'il chevauche l'unité de maintien (2) si l'unité de maintien (2) s'arrête dans la position où l'unité d'entraînement réciproque (5) est située.

3. Dispositif de déplacement de composants électroniques (D) selon
la revendication 1 ou 2,
où le pousseur glissant (53) est disposée de manière à se mouvoir en parallèle à une direction d'avancement de l'unité de maintien (2),
où le moteur d'entraînement réciproque (51) comprend un arbre de moteur qui est perpendiculaire à une direction de mouvement du pousseur glissant (53), et
où un mécanisme à came (52a, 52b) est prévu à être interposé entre le pousseur glissant (53) et le moteur d'entraînement réciproque (51) pour convertir une force de poussée rotationnelle du moteur d'entraînement réciproque (51) dans une force de poussée rectilinéaire agissant dans la direction de mouvement du pousseur glissant (53).

4. Dispositif de déplacement de composants électroniques (D) selon l'une des revendications 1 à 3, l'unité d'entraînement réciproque (5) incluant :
une pièce-ressort .(58a, 58b) pour accumuler une force de précontrainte par le biais de laquelle l'unité de maintien (2) et le pousseur glissant (53) sont retournés vers un centre du rotor (3),
où le pousseur glissant (53) pousse l'unité de maintien (2) à l'extérieur du rotor (3) contre la force de précontrainte de la pièce-ressort (58a).

5. Dispositif de déplacement de composants électroniques (D) selon l'une de revendications 1 à 4, incluant :
un moteur rotatif (4) qui soutient de manière pivotante le centre du rotor (3) par un arbre de moteur de celui-ci, et qui est configuré à tourner le rotor (3) d'une manière intermittente ; et
un panneau de base interposé pour s'étendre entre le rotor (3) et le moteur rotatif (4),
où le moteur d'entraînement réciproque (51) est fixé sur une surface du panneau de base où le moteur rotatif (4) est attaché, et
où le pousseur glissant (53) est disposé sur une surface du panneau de base sur un côté du rotor (3).

6. Dispositif de déplacement de composants électroniques (D) selon la revendication 5,
où le pousseur glissant (53) est disposé d'une telle manière que le pousseur glissant (53) est situé directement à l'arrière de l'unité de maintien (2), ça veut dire un côté de l'unité de maintien (2) est tourné vers une bride de moteur (59), ou il est disposé s'écartant dans une direction radiale ou une direction tangentielle du rotor (3) ou dans une direction qui est parallèle au plan rotatif du rotor (3) et intersecte obliquement avec la direction radiale directement sur un côté arrière de l'unité de maintien (2) si l'unité de maintien (2) s'arrête dans la position où l'unité d'entraînement réciproque (5) est située, et
où le moteur d'entraînement réciproque (51) est disposé directement à l'arrière de l'unité de maintien (2), ça veut dire le côté de l'unité de maintien (2) tournée vers la bride de moteur (59) ou disposée à s'écarter dans la direction radiale ou la direction tangentielle du rotor (3) ou dans la direction qui est parallèle au plan rotatif du rotor (3) et intersecte obliquement avec la direction radiale directement sur le côté arrière de l'unité de maintien (2)..

7. Dispositif de déplacement de composants électroniques (D) selon l'une des revendications 1 à 6,
où le rotor (3) inclut une pluralité des unités de maintien (2) et arrête les unités de maintien (2) dans des positions angulaires qui résultent d'une division d'une circonférence totale du rotor (3) par le nombre des unités de maintien (2) et
où des unités d'entraînement réciproque (5) sont disposées dans toutes les positions d'arrêt des unités de maintien (2).

8. Dispositif de déplacement de composants électroniques (D) selon l'une des revendications 1 à 7,
où le pousseur glissant (53) inclut un moteur à bobine oscillante (8), qui est situé vers l'extérieur du rotor (3) avec sa tige (81) orientée vers la partie saillante (55), et
où le moteur à bobine oscillante (8) pousse l'unité de maintien (2) à dehors en glissant le pousseur glissant (53) et commande une charge exercée sur le composant électronique (D) par une force d'avancement de la tige (81).

9. Système de transport de composants électroniques (D),
qui comprend le dispositif de déplacement de composants électroniques (D) selon l'une des revendications 1 à 8, et
qui est configuré pour implémenter des opérations de conditionnement sur les composants électroniques (D) en transportant lesdits composants électroniques (D) dans une ligne.

10. Système de déplacement de composants électroniques (D) selon la revendication 9, comprenant :
une unité d'alimentation (140) pour contenir les composants électroniques (D) sur lesquels les opérations différentes de conditionnement sont implémentées ;
une unité de maniement (120) pour transporter les composants électroniques (D) dans l'unité d'alimentation (140) dans une ligne le long d'un chemin de transport annulaire (101) ;
des types différents d'unités de conditionnement (110) qui sont disposés le long du chemin de transport (101) ; et
une unité boîtier (150) pour contenir les composants électroniques (D) transportées par l'unité de maniement (120),
où le dispositif de déplacement de composants électroniques (D) est disposé entre l'unité d'alimentation (140) et le chemin de transport (101), servant d'une unité de relais (130) qui saisit le composant électronique (D) dans l'unité d'alimentation (140) pour le transférer à l'unité de maniement (120).

11. Système de transport de composants électroniques (D) selon la revendication 9, comprenant :
une unité d'alimentation (140) pour contenir les composants électroniques (D) sur lesquels les opérations différentes de conditionnement sont implémentées ;
une unité de maniement (120) pour transporter les composants électroniques (D) dans l'unité d'alimentation (140) dans une ligne le long d'un chemin de transport annulaire (101) ;
de types différents d'unités de conditionnement (110) disposés le long du chemin de transport (101) ; et
une unité boîtier (150) pour contenir les composants électroniques (D) transportés par l'unité de maniement (120),
où une pluralité dispositifs de déplacement de composants électroniques (D) sont situées en succession, constituant l'unité de maniement (120).

12. Dispositif de déplacement de composants électroniques (D) selon l'une des revendications 1 à 7,
où, vue de la direction qui est perpendiculaire au plan rotatif du rotor (3), l'un du pousseur glissant (53) et du moteur d'entraînement réciproque (51) comporte une superficie qui est supérieure à une superficie de l'autre du pousseur glissant (53) et du moteur d'entraînement réciproque (51)
où, vue de la direction qui est perpendiculaire au plan rotatif du rotor (3), la superficie de l'autre du pousseur glissant (53) et du moteur d'entraînement réciproque (51) est contenue dans la superficie de l'un du pousseur glissant (53) et du moteur d'entraînement réciproque (51).
